# EUROPEAN PATENT APPLICATION

(11) **EP 4 561 290 A1**
(43) Date of publication of application: **28.05.2025**
(21) Application number: 24192079.2
(22) Date of filing: 31.07.2024
(51) Int. Cl.: H10B 43/27, H10D 30/01, H10D 30/63

(54) **SEMICONDUCTOR DEVICES AND DATA STORAGE SYSTEMS INCLUDING THE SAME**

(30) Priority: 22.11.2023 KR 20230163093
(71) Applicant: SAMSUNG ELECTRONICS CO., LTD., Yeongtong-gu Suwon-si, Gyeonggi-do 16677 (KR)
(72) Inventor: CHOI, Hyunmook, 16677 Suwon-si (KR); YUN, Kangoh, 16677 Suwon-si (KR)
(74) Representative: Marks & Clerk LLP

(57) **Abstract**

A semiconductor device includes a first substrate structure including a substrate, first circuit devices on the substrate, second circuit devices that extend into the substrate, a gate isolation layer penetrating the substrate and between the second circuit devices, and a second substrate structure electrically connected to the first substrate structure on the first substrate structure, and including gate electrodes electrically connected to the first and second circuit devices. Adjacent second circuit devices among the second circuit devices are disposed symmetrically with respect to the gate isolation layer.

## Description

### BACKGROUND

Example embodiments of the present disclosure relate to a semiconductor device and a data storage system including the same.

A semiconductor device able to store high-capacity data in a data storage system with data storage has been needed. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been suggested. To increase integration density of a semiconductor device, a method of reducing an area of circuit elements driving memory cells are has been studied.

### SUMMARY

Example embodiments of the present disclosure is to provide a semiconductor device having improved integration density.

Example embodiments of the present disclosure is to provide a data storage system including a semiconductor device having improved integration density.

According to example embodiments of the present disclosure, a semiconductor device includes a first substrate structure including a substrate, first circuit devices on the substrate, second circuit devices that extend into the substrate, and a second substrate structure electrically connected to the first substrate structure on the first substrate structure and including a plate layer, gate electrodes stacked and spaced apart from each other below the plate layer in a first direction perpendicular to a lower surface of the plate layer that faces the first substrate structure, and channel structures that extend into the gate electrodes, extend in the first direction, and each include a channel layer. Each of the second circuit devices includes a second gate dielectric layer that extend into the substrate and extends in the first direction, a second gate electrode layer on the second gate dielectric layer, and a second source/drain regions that extend into the substrate from opposing upper and lower surfaces of the substrate, respectively. The second substrate structure further includes a gate isolation layer that extend into the substrate between the second circuit devices adjacent to each other and is in contact with the second gate electrode layer.

According to example embodiments of the present disclosure, a semiconductor device includes a first substrate structure including a substrate, first circuit devices on the substrate, second circuit devices that extend into the substrate, and a gate isolation layer that extend into the substrate and is between ones of the second circuit devices, and a second substrate structure electrically connected to the first substrate structure on the first substrate structure, and including gate electrodes electrically connected to the first and second circuit devices. Adjacent second circuit devices among the second circuit devices are disposed symmetrically with respect to the gate isolation layer.

According to example embodiments of the present disclosure, a data storage system includes a semiconductor storage device including a first substrate structure including a substrate and first circuit devices and second circuit devices, a second substrate structure including gate electrodes, and an input/output pad electrically connected to the first and second circuit devices, and a controller electrically connected to the semiconductor storage device by the input/output pad and configured to control the semiconductor storage device. The first circuit devices are on the substrate, and the second circuit devices extend into the substrate. The first substrate structure further includes a gate isolation layer that extends into the substrate and is between ones of the second circuit devices, a backside insulating layer on a lower surface of the substrate, and a lower active contact plug that extends into the backside insulating layer and is electrically connected to the second circuit devices.

At least some of the above and other features of the disclosure are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a cross-sectional view illustrating a semiconductor device according to example embodiments of the present disclosure;
FIG. 2 is a plan view illustrating a semiconductor device according to example embodiments of the present disclosure;
FIGS. 3A and 3B are enlarged diagrams illustrating a portion of a semiconductor device according to example embodiments of the present disclosure;
FIG. 4 is an enlarged diagram illustrating a portion of a semiconductor device according to example embodiments of the present disclosure;
FIGS. 5A and 5B are enlarged diagrams illustrating a semiconductor device according to example embodiments of the present disclosure;
FIGS. 6A, 6B, and 6C are enlarged diagrams illustrating a portion of a semiconductor device according to example embodiments of the present disclosure;
FIG. 7 is a cross-sectional view illustrating a semiconductor device according to example embodiments of the present disclosure;
FIG. 8 is a cross-sectional view illustrating a semiconductor device according to example embodiments of the present disclosure;
FIGS. 9A, 9B, 9C, 9D, 9E, 9F, 9G, 9H, 9I, 9J, 9K, 9L, 9M, 9N, 90, and 9P are cross-sectional views illustrating a method of manufacturing a semiconductor device according to example embodiments of the present disclosure;
FIG. 10 is a view illustrating a data storage system including a semiconductor device according to example embodiments of the present disclosure;
FIG. 11 is a perspective view illustrating a data storage system including a semiconductor device according to example embodiments of the present disclosure; and
FIG. 12 is a cross-sectional view illustrating a semiconductor package according to example embodiments of the present disclosure.

### DETAILED DESCRIPTION

Hereinafter, embodiments of the present disclosure will be described as follows with reference to the accompanying drawings.

It will be understood that, although the terms "first", "second", "third", and so on may be used herein to illustrate various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly. The term "and/or" includes any and all combinations of one or more of the associated listed items.

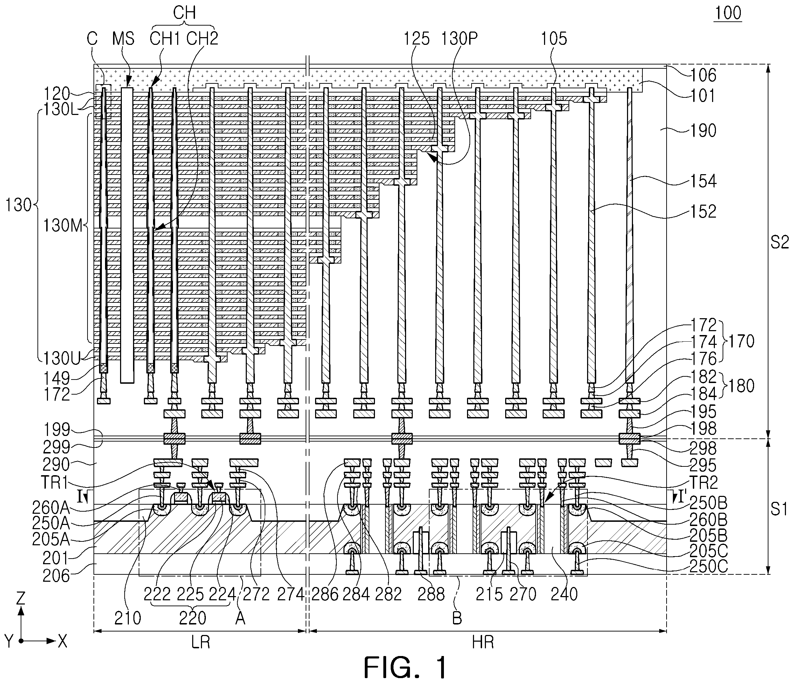

FIG. 1 is a cross-sectional view illustrating a semiconductor device according to example embodiments.

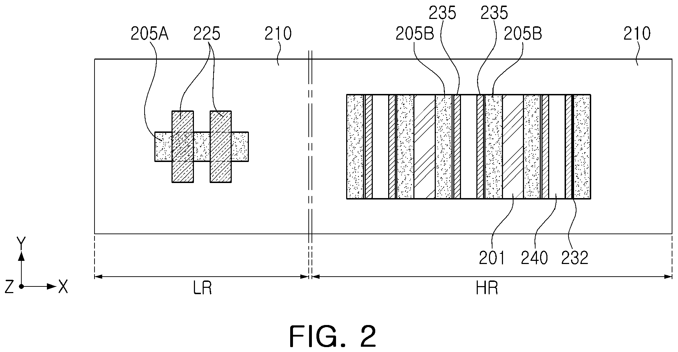

FIG. 2 is a plan view illustrating a semiconductor device according to example embodiments, taken along line I-I'.

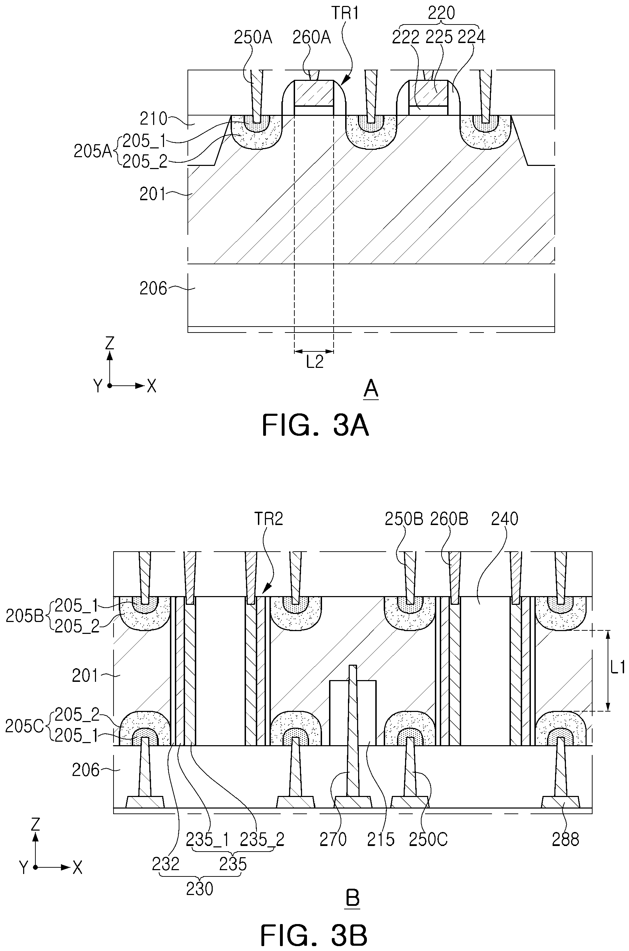

FIGS. 3A and 3B are enlarged diagrams illustrating a portion of a semiconductor device according to example embodiments. FIG. 3A is an enlarged view of region 'A' in FIG. 1, and FIG. 3B is an enlarged view of region 'B' in FIG. 1.

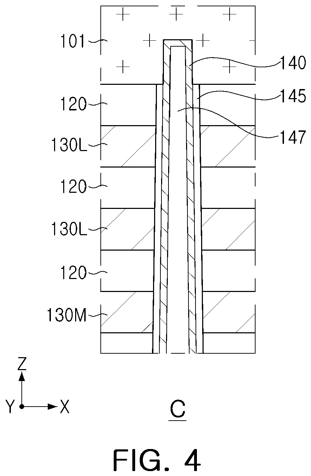

FIG. 4 is an enlarged diagram illustrating a portion of a semiconductor device according to example embodiments, illustrating region 'C' in FIG. 1.

Referring to FIGS. 1, 2, 3A, 3B, and 4, a semiconductor device 100 may include first and second substrate structures S1 and S2 bonded to each other vertically. The first substrate structure S1 may include a peripheral circuit region, and the second substrate structure S2 may include a memory cell region.

The first substrate structure S1 may have a first device region LR and a second device region HR. The first substrate structure S1 may include a substrate 201, device isolation layers 210 in the substrate 201, first circuit devices TR1 disposed on the substrate 201 in the first device region LR, second circuit devices TR2 disposed to penetrate or extend into the substrate 201 in second device region HR, a peripheral region insulating layer 290 on the upper surface of the substrate 201, a backside insulating layer 206 on a lower surface of the substrate 201, first and second circuit contact plugs 272 and 274 on the substrate 201, first to third circuit interconnection lines 282, 284, and 286, first bonding vias 295, first bonding pads 298, and a first bonding insulating layer 299.

The first substrate structure S1 may further include first source/drain regions 205A, first upper active contact plugs 250A, and first gate contact plugs 260A, disposed in the first device region LR. The first substrate structure S1 may further include substrate insulating layers 215, gate isolation layers 240, second source/drain regions 205B and 205C, second upper active contact plugs 250B, second gate contact plugs 260B, lower active contact plugs 250C, body contact plugs 270, and backside interconnection lines 288, disposed in the second device region HR.

The substrate 201 may have an upper surface extending in the X-direction and the Y-direction. The device isolation layers 210 may be formed on the substrate 201 such that active regions may be defined. The first and second source/drain regions 205A, 205B, and 205C including impurities may be disposed in a portion of the active regions. The substrate 201 may include a semiconductor material, such as a group IV semiconductor, a group III-V compound semiconductor, or a group II-VI compound semiconductor. For example, the substrate 201 may be provided as a single crystal bulk wafer.

The device isolation layers 210 may define active regions in the substrate 201. The device isolation layers 210 may be disposed in the first device region LR, and may be disposed in a region including at least an edge in the second device region HR. The device isolation layers 210 may be formed, for example, by a shallow trench isolation (STI) process. In example embodiments, the arrangement form and a depth of the device isolation layers 210 may be varied. The device isolation layers 210 may be formed of insulating material. The device isolation layer 210 may be, for example, oxide, nitride, or a combination thereof.

The first circuit devices TR1 may be disposed on an upper surface of the substrate 201 and may include a planar transistor. Each of the first circuit devices TR1 may include a first gate structure 220 and first source/drain regions 205A. The first gate structure 220 may include a first gate dielectric layer 222, a first gate electrode layer 225, and first gate spacers 224.

The first gate dielectric layer 222 may be disposed on an upper surface of the substrate 201 and may include oxide, nitride, or a high-κ material. The high-κ material may refer to a dielectric material having a dielectric constant higher than that of a silicon oxide film (SiO₂).

The first gate electrode layer 225 may be disposed on the first gate dielectric layer 222 and may include a conductive material. The first gate electrode layer 225 may include, for example, metal nitride such as titanium nitride (TiN), tantalum nitride (TaN), or tungsten nitride (WN), and/or a metal material such as aluminum (Al), tungsten (W), or molybdenum (Mo), or a semiconductor material such as doped polysilicon. In example embodiments, the first gate electrode layer 225 may include two or more conductive layers.

The first gate spacers 224 may be disposed on both side surfaces of the first gate electrode layer 225. The first gate spacers 224 may insulate the first source/drain regions 205A and the first gate electrode layer 225. The first gate spacers 224 may be formed of at least one of oxide, nitride, and/or oxynitride, and may be formed of a low dielectric constant film, for example.

The first source/drain regions 205A may be disposed in the substrate 201 on both sides of the first gate structure 220. The first source/drain regions 205A may include first and second impurity regions 205_1 and 205_2 having different doping concentrations. However, in example embodiments, the shape of the impurity regions forming the first source/drain regions 205A and the number of the impurity regions may be varied.

The second circuit devices TR2 may penetrate through or extend into the substrate 201 and may be disposed in the substrate 201, and may include a vertical transistor. Each of the second circuit devices TR2 may include a second gate structure 230 and second source/drain regions 205B and 205C. The second gate structure 230 may include a second gate dielectric layer 232 and a second gate electrode layer 235. The second gate structure 230 and two second source/drain regions 205B and 205C adjacent to the second gate structure 230 may form a vertical transistor, and the semiconductor device 100 may include at least two vertical transistors opposing the gate isolation layer 240.

The second gate dielectric layer 232 may be disposed to penetrate through or extend into the substrate 201 and to extend in the Z-direction. The second gate dielectric layer 232 may extend only in the Z-direction in a cross-sectional view without a region extending in a direction parallel to an upper surface of the substrate 201, such as the X-direction, as illustrated in FIG. 1. The second gate dielectric layer 232 may have a shape of the alphabet 'I' or the number ` 1' in the cross-sectional view in FIG. 1. An upper surface of the second gate dielectric layer 232 may be coplanar with the upper surface of the substrate 201, and a lower surface may be coplanar with a lower surface of the substrate 201. A thickness of the second gate dielectric layer 232 may be greater than a thickness of the first gate dielectric layer 222, but example embodiments thereof is not limited thereto. The second gate dielectric layer 232 may include the same material as or different from that of the first gate dielectric layer 222, and may include oxide, nitride, or a high-κ material.

The second gate electrode layer 235 may be disposed on the second gate dielectric layer 232 and may extend in the Z-direction through the substrate 201. The second gate electrode layer 235 may not extend in a direction parallel to the upper surface of the substrate 201, such as in the X-direction, and may extend in the Z-direction in the cross-sectional view as in FIG. 1. The second gate electrode layer 235 may have the shape of the alphabet 'I' or the number ` 1' in the cross-sectional view in FIG. 1. An upper surface of the second gate electrode layer 235 may be coplanar with the upper surface of the substrate 201, and a lower surface may be coplanar with a lower surface of the substrate 201. A thickness of the second gate electrode layer 235 may be greater than a thickness of the first gate electrode layer 225, but example embodiments thereof is not limited thereto. The second gate electrode layer 235 may include first and second conductive layers 235_1 and 235_2 stacked in order from the second gate dielectric layer 232. The first and second conductive layers 235_1 and 235_2 may include different materials. For example, the first conductive layer 235_1 may include a semiconductor material such as doped polysilicon, and the second conductive layer 235_2 may include a metal material such as aluminum (Al), tungsten (W), or molybdenum (Mo). However, in example embodiments, the number of conductive layers forming the second gate electrode layer 235 may be varied.

The second source/drain regions 205B and 205C may include second upper source/drain regions 205B disposed at a predetermined depth from the upper surface of the substrate 201 and second lower source/drain regions 205C disposed at a predetermined depth from the lower surface of the substrate 201. Upper surfaces of the second upper source/drain regions 205B may be coplanar with the upper surface of the substrate 201, and lower surfaces of the second lower source/drain regions 205C may be coplanar with the lower surface of the substrate 201. The second source/drain regions 205B and 205C may include first and second impurity regions 205_1 and 205_2 having different doping concentrations, respectively. The second source/drain regions 205B and 205C may have a structure the same as or different from the first source/drain regions 205A, and the number of impurity regions included in the second source/drain regions 205B and 205C and the shape thereof may be varied in example embodiments.

A channel direction of the first circuit device TR1 may be perpendicular to a channel direction of the second circuit device TR2. The channel direction of the first circuit device TR1 may be a direction parallel to the upper surface of the substrate 201, for example, the X-direction, and the channel direction of the second circuit device TR2 may be a direction perpendicular to the upper surface of the substrate 201, for example, the Z-direction.

In the second circuit device TR2, the channel length may correspond to a first length L1, which is a length of the second gate electrode layer 235 between the second source/drain regions 205B and 205C disposed side by side in the vertical direction. The first length L1 may be in a range of about 10 µm to about 50 µm, for example, from about 10 µm to about 20 µm. When manufacturing the semiconductor device 100, a thickness of the substrate 201 may be determined by considering the first length L1.

In the first circuit device TR1, the channel length may correspond to a second length L2, which is a length of the first gate electrode layer 225 between the first source/drain regions 205A disposed side by side in the horizontal direction. The second length L2 may be smaller than the first length L1. For example, the second circuit device TR2 may be a high voltage transistor to which a relatively high voltage is applied as compared to the first circuit device TR1.

In the semiconductor device 100, the second circuit devices TR2 having a relatively long channel length may be disposed in the form of a backside contact vertical transistor (BCVT) penetrating the substrate 201, such that integration density may improve, differently from when the second circuit devices TR2 is disposed as a planar transistor. For example, the second circuit devices TR2 may be selected as devices having the longest channel length among the transistors disposed on the first substrate structure S1, or as devices having a relatively long channel length, a plurality of which may be disposed or which may occupy a relatively wide area.

The gate isolation layer 240 may be disposed between second circuit devices TR2 adjacent to each other. The gate isolation layer 240 may be disposed to completely penetrate or extend into the substrate 201. As illustrated in FIG. 2, the gate isolation layer 240 may include a region having a quadrangular shape between at least the second circuit devices TR2 on the plan view. The gate isolation layer 240 may be disposed between the second gate electrode layers 235 of the second circuit devices TR2 adjacent to each other, and may be in contact with the second gate electrode layers 235 through both side surfaces. The second circuit devices TR2 adjacent to each other may be disposed symmetrically with respect to the gate isolation layer 240. The gate isolation layer 240 may include an insulating material, for example, at least one of oxide, nitride, and/or oxynitride. Such an arrangement may improve performance of the second circuit devices TR2 and accordingly the semiconductor device 100.

The peripheral region insulating layer 290 may be disposed on the first and second circuit devices TR1 and TR2 on the upper surface of the substrate 201. The backside insulating layer 206 may be disposed on the lower surface of the substrate 201. Each of the peripheral region insulating layer 290 and the backside insulating layer 206 may include a plurality of insulating layers formed in different processes. Each of the peripheral region insulating layer 290 and the backside insulating layer 206 may be formed of an insulating material, and may include, for example, at least one of oxide, nitride, and/or oxynitride.

The first upper active contact plugs 250A may be connected to the first source/drain regions 205A through the peripheral region insulating layer 290. The second upper active contact plugs 250B may be connected to the second upper source/drain regions 205B through the peripheral region insulating layer 290. The first and second upper active contact plugs 250A and 250B may be connected to the first impurity regions 205_1, which include relatively high impurities, but example embodiments thereof is not limited thereto.

The first gate contact plugs 260A may penetrate or extend into the peripheral region insulating layer 290 and may be connected to the first gate electrode layers 225. The second gate contact plugs 260B may penetrate through or extend into the peripheral region insulating layer 290 and may be connected to the second gate electrode layers 235. The second gate contact plugs 260B may be connected to the second conductive layers 235_2, but example embodiments thereof is not limited thereto.

Ones of the first and second upper active contact plugs 250A and 250B and/or the first and second gate contact plugs 260A and 260B may have a side surface inclined such that a width of an upper surface thereof may be greater than a width of a lower surface. Upper ends of the first and second upper active contact plugs 250A and 250B and upper ends of the first and second gate contact plugs 260A and 260B may be disposed on substantially the same level, but example embodiments thereof are not limited thereto.

The lower active contact plugs 250C may be connected to the second lower source/drain regions 205C through the backside insulating layer 206. Each of the lower active contact plugs 250C may have a side surface inclined such that a width of an upper surface thereof may be smaller than a width of a lower surface. A slope of side surfaces of the lower active contact plugs 250C may be opposite to a slope of side surfaces of the first and second upper active contact plugs 250A and 250B with respect to the substrate 201.

The body contact plugs 270 may be connected to the substrate 201 through the backside insulating layer 206 and the substrate insulating layer 215. The body contact plugs 270 may be disposed between and/or around the second circuit devices TR2. The body contact plugs 270 may be configured to apply a body voltage to the substrate 201. Upper ends of the body contact plugs 270 may be disposed on a level higher than a level of upper ends of the lower active contact plugs 250C, and may be disposed on a level lower than a level of lower ends of the first and second upper active contact plugs 250A and 250B and lower ends of the first and second gate contact plugs 260A and 260B.

Each of the first and second upper active contact plugs 250A and 250B, the first and second gate contact plugs 260A and 260B, the lower active contact plugs 250C, and the body contact plugs 270, which form a portion of the first interconnection structure in the first substrate structure S1, may have a cylindrical shape. The first and second upper active contact plugs 250A and 250B, the first and second gate contact plugs 260A and 260B, the lower active contact plugs 250C, and the body contact plugs 270 may include a conductive material, for example, at least one of a semiconductor material, a metal-semiconductor compound, or a metal material such as tungsten (W), cobalt (Co), molybdenum (Mo), copper (Cu), ruthenium (Ru), and/or aluminum (Al), and each may further include a diffusion barrier.

The substrate insulating layer 215 may extend from a lower surface of the substrate 201 into the substrate 201 to a predetermined depth and may surround a portion of a side surface of the body contact plug 270. The substrate insulating layer 215 may be disposed in an upper portion of the body contact plug 270 to expose the side surface and an upper end of the body contact plug 270. The substrate insulating layer 215 may be formed of an insulating material and may include, for example, at least one of oxide, nitride, and/or oxynitride.

The first and second circuit contact plugs 272 and 274 and the first to third circuit interconnection lines 282, 284, and 286 may form a portion of the first interconnection structure and may be disposed on an upper surface of the substrate 201, and may be connected to the first and second upper active contact plugs 250A and 250B and the first and second gate contact plugs 260A and 260B.

The backside interconnection lines 288, which form a portion of the first interconnection structure, may be disposed on the lower surface of the substrate 201 and may be connected to the lower active contact plugs 250C and the body contact plugs 270. At least a portion of the backside interconnection lines 288 may form a backside power delivery network (BSPDN) and may transfer power to the second circuit devices TR2 in this case.

Each of the first and second circuit contact plugs 272 and 274 may have a cylindrical shape. Each of the first to third circuit interconnection lines 282, 284, and 286 and the backside interconnection lines 288 may have a line form. The first and second circuit contact plugs 272 and 274, the first to third circuit interconnection lines 282, 284, and 286, and the backside interconnection lines 288 may include a conductive material, such as tungsten (W), copper (Cu), aluminum (Al), and each may further include a diffusion barrier. However, in example embodiments, the number of layers of the first and second circuit contact plugs 272 and 274, the first to third circuit interconnection lines 282, 284, and 286, and the backside interconnection lines 288 and the arrangement form thereof may be varied.

First bonding vias 295, first bonding pads 298, and a first bonding insulating layer 299 may be included in the first bonding structure and may be disposed on the uppermost third circuit interconnection lines 286. The first bonding vias 295 may have a cylindrical shape, and the first bonding pads 298 may have a line shape. Upper surfaces of the first bonding pads 298 and upper surfaces of the first bonding insulating layer 299 may be exposed to an upper surface of the first substrate structure S1. The first bonding vias 295 and the first bonding pads 298 may provide an electrical connection path between the first substrate structure S1 and the second substrate structure S2. A portion of the first bonding pads 298 may not be connected to the lower third circuit interconnection line 286 and may be disposed for bonding. The first bonding vias 295 and the first bonding pads 298 may include a conductive material, for example, copper (Cu). The first bonding insulating layer 299 may be disposed around the first bonding pads 298. The first bonding insulating layer 299 may also function as a diffusion barrier of the first bonding pads 298 and may include, for example, at least one of SiN, SiON, SiCN, SiOC, SiOCN, and/or SiO.

The second substrate structure S2 may include a plate layer 101, gate electrodes 130 stacked on a lower surface of the plate layer 101, interlayer insulating layers 120 alternately stacked with the gate electrodes 130, channel structures CH penetrating the gate electrodes 130, an isolation region MS penetrating the gate electrodes 130 and extending in one direction, first cell contact plugs 152 connected to gate electrodes 130, and a second cell contact plug 154 electrically connected to the plate layer 101. The second substrate structure S2 may further include a cover insulating layer 105, a passivation layer 106, contact insulating layers 125, cell upper contacts 170, cell interconnection lines 180, and cell region insulating layers 190. The second substrate structure S2 may further include second bonding vias 195, second bonding pads 198, and a second bonding insulating layer 199, as a second bonding structure.

The plate layer 101 may have an upper surface extending in the X-direction and Y-direction. The plate layer 101 may function as a common source line of the semiconductor device 100. The plate layer 101 may include a conductive material. For example, the plate layer 101 may include a semiconductor material, such as a group IV semiconductor, a group III-V compound semiconductor, or a group II-VI compound semiconductor. For example, a group IV semiconductor may include silicon, germanium, or silicon-germanium. The plate layer 101 may further include impurities. The plate layer 101 may be provided as a polycrystalline semiconductor layer such as a polycrystalline silicon layer or an epitaxial layer. In some example embodiments, the plate layer 101 may include a plurality of conductive layers stacked vertically.

The gate electrodes 130 may be vertically stacked and spaced apart from each other on a lower surface of the plate layer 101 and may form a stack structure with the interlayer insulating layers 120. The stack structure may be vertically stacked and may include lower and upper stack structures surrounding the first and second channel structures CH1 and CH2, respectively. However, in example embodiments, the stack structure may include a single stack structure.

The gate electrodes 130 may include at least one lower gate electrode 130L forming a gate of the ground select transistor, memory gate electrodes 130M forming a plurality of memory cells, and upper gate electrodes 130U forming gates of the string select transistors. Here, the terms "lower" and "upper" of the lower and upper stack structures, the lower gate electrode 130L, and the upper gate electrodes 130U may be denoted with respect to the direction during a manufacturing process. Depending on capacity of the semiconductor device 100, the number of the memory gate electrodes 130M forming the memory cells may be determined. In example embodiments, the number of each of the upper and lower gate electrodes 130U and 130L may be 1 to 4 or more, and may have a structure the same as or different from that of the memory gate electrodes 130M. In example embodiments, the gate electrodes 130 may further include a gate electrode 130 disposed below the upper gate electrodes 130U and/or on the lower gate electrode 130L and forming an erase transistor used in an erase operation using gate induced drain leakage (GIDL) phenomenon. A portion of the gate electrodes 130, for example, the memory gate electrodes 130M adjacent to the upper or lower gate electrodes 130U and 130L may be dummy gate electrodes.

The gate electrodes 130 may be vertically stacked and spaced apart from each other, may extend to different lengths in at least one direction, for example, the Y-direction, and may form a step structure having a staircase shape. The gate electrodes 130 may be disposed to have a step structure with each other in the X-direction. Due to the step structure, the gate electrodes 130 in an upper portion may extend longer than the gate electrode 130 in a lower portion, such that the gate electrodes may have regions in which the lower surfaces may be exposed below from the interlayer insulating layers 120 and the other gate electrodes 130, and the regions may be referred to as pad regions 130P. The gate electrodes 130 may be connected to the first cell contact plugs 152 in the pad regions 130P. The gate electrodes 130 may have an increased thickness in the pad regions 130P.

The gate electrodes 130 may include a metal material, such as tungsten (W). In example embodiments, the gate electrodes 130 may include polycrystalline silicon or metal silicide material. In example embodiments, the gate electrodes 130 may further include a diffusion barrier. For example, the diffusion barrier may include tungsten nitride (WN), tantalum nitride (TaN), titanium nitride (TiN), or a combination thereof.

The interlayer insulating layers 120 may be disposed between the gate electrodes 130. Similarly to the gate electrodes 130, the interlayer insulating layers 120 may be disposed to be spaced apart from each other in a direction perpendicular to a lower surface of the plate layer 101 and to extend in the Y-direction. The interlayer insulating layers 120 may include an insulating material such as silicon oxide or silicon nitride.

Each of the channel structures CH may form a memory cell string and may be spaced apart from each other in rows and columns on the lower surface of the plate layer 101. The channel structures CH may be disposed to form a grid pattern on a plan view or may be disposed in a zigzag pattern in one direction. The channel structures CH may have a pillar shape and may have an inclined side surface such that a width thereof may decrease toward the plate layer 101 depending on an aspect ratio.

Each of the channel structures CH may have a form in which the first and second channel structures CH1 and CH2 penetrating the lower and upper stack structures of the gate electrodes 130, respectively, may be connected to each other, and may have a bent portion due to a difference or a change in width in the connection region. However, in example embodiments, the number of channel structures stacked in the Z-direction may be varied.

Each of the channel structures CH may include a channel layer 140, a gate dielectric layer 145, a channel filling insulating layer 147, and a channel pad 149 disposed in the channel hole. The channel layer 140 may be formed as an annular shape surrounding the internal channel filling insulating layer 147, but in example embodiments, the channel layer 140 may have a pillar shape such as a cylindrical shape or a prism shape without the channel filling insulating layer 147. The channel layer 140 may include a semiconductor material such as polycrystalline silicon or single crystalline silicon. The channel layer 140 may be exposed through an upper end and may be connected to the plate layer 101.

As illustrated in FIG. 4, on an upper end of the channel structure CH, an upper end of the channel layer 140 may be exposed from the channel dielectric layer or gate dielectric layer 145. The upper end of the channel layer 140 may include an upper surface and an upper region of a side surface connected to the upper surface. An upper end of channel layer 140 may be in direct contact with the plate layer 101 and may be surrounded by the plate layer 101 in plan view. By this arrangement, the channel layer 140 may be physically and electrically connected to the plate layer 101.

The gate dielectric layer 145 may be disposed between the gate electrodes 130 and the channel layer 140. Although not specifically illustrated, the gate dielectric layer 145 may include a tunneling layer, a charge storage layer, and a blocking layer stacked in order from the channel layer 140. The tunneling layer may tunnel charges into the charge storage layer, and may include, for example, silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), a high-κ dielectric material, or a combination thereof. In example embodiments, at least a portion of the gate dielectric layer 145 may extend in a horizontal direction along the gate electrodes 130.

The channel pad 149 may be disposed on a lower end of the second channel structure CH2 of a lower portion. The channel pads 149 may include, for example, doped polycrystalline silicon.

The channel layer 140, the gate dielectric layer 145, and the channel filling insulating layer 147 may be connected to each other between the first channel structure CH1 and the second channel structure CH2. An interlayer insulating layer 120 having a relatively high thickness may be further disposed between the first channel structure CH1 and the second channel structure CH2. However, the form of the interlayer insulating layers 120 may be varied in example embodiments.

The isolation region MS may be disposed to extend through the gate electrodes 130 in one direction, for example, the Y-direction. Although only one isolation region MS is illustrated in FIG. 1, the plurality of isolation regions MS may extend parallel to each other in the Y-direction and may be spaced apart from each other in the X-direction. The isolation region MS may penetrate or extend into the entirety of the gate electrodes 130 stacked on the plate layer 101 and may be connected to the plate layer 101.

The isolation region MS may have a shape in which a width thereof may decrease toward the plate layer 101 due to a high aspect ratio, but example embodiments thereof is not limited thereto. The isolation region MS may include an insulating material, for example, silicon oxide, silicon nitride, or silicon oxynitride.

The first and second cell contact plugs 152 and 154 may extend in the Z-direction and may have an inclined side surface such that a width may decrease toward the plate layer 101. Upper ends of the first and second cell contact plugs 152 and 154 may be disposed on a lower surface of the plate layer 101, for example at the lower surface of the plate layer 101 or in the plate layer 101. The first and second cell contact plugs 152 and 154 may form a portion of the second interconnection structure in the second substrate structure S2.

The first cell contact plugs 152 may electrically connect the gate electrodes 130 to the first interconnection structure in the first substrate structure S1. The first cell contact plugs 152 may be physically and electrically connected to the gate electrodes 130 in each of pad regions 130P, and may apply an electrical signal to the gate electrodes 130. The first cell contact plugs 152 may penetrate or extend into the pad regions 130P of the gate electrodes 130. The first cell contact plugs 152 may be disposed such that the gate electrodes 130 may penetrate through or extend into a region forming the staircase structure and may extend into the plate layer 101. The first cell contact plugs 152 may be electrically isolated from the plate layer 101 by the cover insulating layer 105. However, in some example embodiments, the first cell contact plugs 152 may have a shape not penetrating the gate electrodes 130. In this case, the first cell contact plugs 152 may extend to connect to a lower surface or a lower portion of each of the gate electrodes 130.

The first cell contact plugs 152 may be configured to be horizontally expanded in the pad regions 130P. The first cell contact plugs 152 may be spaced apart from the gate electrodes 130 on the pad regions 130P by contact insulating layers 125. The contact insulating layers 125 may surround a side surface of the first cell contact plug 152 and may be spaced apart from each other in the Z-direction. The contact insulating layers 125 may be disposed on substantially the same level as a level of the gate electrodes 130, respectively. The contact insulating layers 125 may include an insulating material, such as silicon oxide, silicon nitride, or silicon oxynitride.

The second cell contact plugs 154 may be disposed in a region in which the gate electrodes 130 are not disposed, for example, on an external side of the gate electrodes 130. The second cell contact plug 154 may electrically connect the first and second circuit devices TR1 and TR2 of the first substrate structure S1 to the plate layer 101. The second cell contact plug 154 may penetrate through or extend into a portion of the cell region insulating layer 190 and may extend into the plate layer 101.

The first and second cell contact plugs 152 and 154 may include a metal material, such as tungsten (W), aluminum (Al), copper (Cu), tungsten nitride (WN), tantalum nitride (TaN), titanium nitride (TiN), or a combination thereof.

The cover insulating layer 105 may be disposed between the first cell contact plugs 152 and the plate layer 101. The cover insulating layer 105 may cover or overlap upper ends of the first cell contact plugs 152. The cover insulating layer 105 may not extend to the channel structures CH and the second cell contact plug 154. An upper surface of the cover insulating layer 105 may have a curve along upper ends of the first cell contact plugs 152, but the shape of the upper surface of the cover insulating layer 105 is not limited thereto. The cover insulating layer 105 may include an insulating material, for example, at least one of silicon oxide, silicon nitride, and/or silicon carbide. In some example embodiments, the cover insulating layer 105 may be spaced apart from each other in a plurality of layers between the first cell contact plugs 152. In some example embodiments, the cover insulating layer 105 may be disposed to penetrate or extend into the plate layer 101.

Cell upper contacts 170 and cell interconnection lines 180 may form a portion of the second interconnection structure and may allow the second substrate structure S2 to be electrically connected to the first substrate structure S 1.

The cell upper contacts 170 may include first to third cell upper contacts 172, 174, and 176, and the cell interconnection lines 180 may include first and second cell interconnection lines 182 and 184. The channel pads 149 and the first and second cell contact plugs 152 and 154 may be connected to the first cell upper contacts 172 on lower ends. The first cell upper contacts 172 may be connected to the second cell upper contacts 174 on lower ends, and the second cell upper contacts 174 may be connected to the first cell interconnection lines 182 on lower ends. The third cell upper contacts 176 may connect the first and second cell interconnection lines 182 and 184 to each other upwardly and downwardly. The cell upper contacts 170 may have a cylindrical shape. In example embodiments, the cell upper contacts 170 may have an inclined side surface having a width decreasing toward the plate layer 101 and increasing toward the first substrate structure S1 depending on an aspect ratio.

The first cell interconnection lines 182 may include bit lines connected to the channel structures CH and interconnection lines disposed on the same level as the bit lines. The second cell interconnection lines 184 may be the interconnection lines disposed below the first cell interconnection lines 182. The cell interconnection lines 180 may have a line shape extending in at least one direction. In example embodiments, the second cell interconnection lines 184 may have a thickness greater than that of the first cell interconnection lines 182. The cell interconnection lines 180 may have a side surface inclined such that a width thereof may decrease toward the plate layer 101.

The cell upper contacts 170 and the cell interconnection lines 180 may include, for example, tungsten (W), aluminum (Al), copper (Cu), tungsten nitride (WN), tantalum nitride (TaN), titanium nitride (TiN), or a combination thereof.

The second bonding vias 195 of the second bonding structure may be disposed below the second cell interconnection lines 184 and may be connected to the second cell interconnection lines 184, and the second bonding pads 198 of the second bonding structure may be connected to the second bonding vias 195. Lower surfaces of the second bonding pads 198 may be exposed to a lower surface of the second substrate structure S2. The second bonding pads 198 may be connected to the first bonding pads 298 of the first substrate structure S1 by bonding, and the second bonding insulating layer 199 may be connected to the first bonding insulating layer 299 of the first substrate structure S1 by bonding. The second bonding vias 195 and the second bonding pads 198 may include a conductive material, for example, copper (Cu). The second bonding insulating layer 199 may include, for example, at least one of SiO, SiN, SiCN, SiOC, SiON, and/or SiOCN.

The first and second substrate structures S1 and S2 may be bonded to each other by bonding between the first bonding pads 298 and the second bonding pads 198 and bonding between the first bonding insulating layer 299 and the second bonding insulating layer 199. The bonding between the first bonding pads 298 and the second bonding pads 198 may be, for example, copper (Cu)-to-copper (Cu) bonding, and the bonding between the first bonding insulating layer 299 and the second bonding insulating layer 199 may be, for example, dielectric-to-dielectric bonding such as SiCN-to-SiCN bonding. The first and second substrate structures S1 and S2 may be bonded to each other by hybrid bonding including copper (Cu)-to-copper (Cu) bonding and dielectric-to-dielectric bonding.

The cell region insulating layer 190 may be disposed to cover or overlap a lower surface of the plate layer 101 and the gate electrodes 130 on the lower surface of the plate layer 101. A passivation layer 106 may be disposed on an upper surface of plate layer 101 and may have an opening exposing an input/output pad region. The passivation layer 106 may function as a layer protecting the semiconductor device 100.

The cell region insulating layer 190 and the passivation layer 106 may include at least one of an insulating material, for example, silicon oxide, silicon nitride, and/or silicon carbide, and may include a plurality of insulating layers in example embodiments.

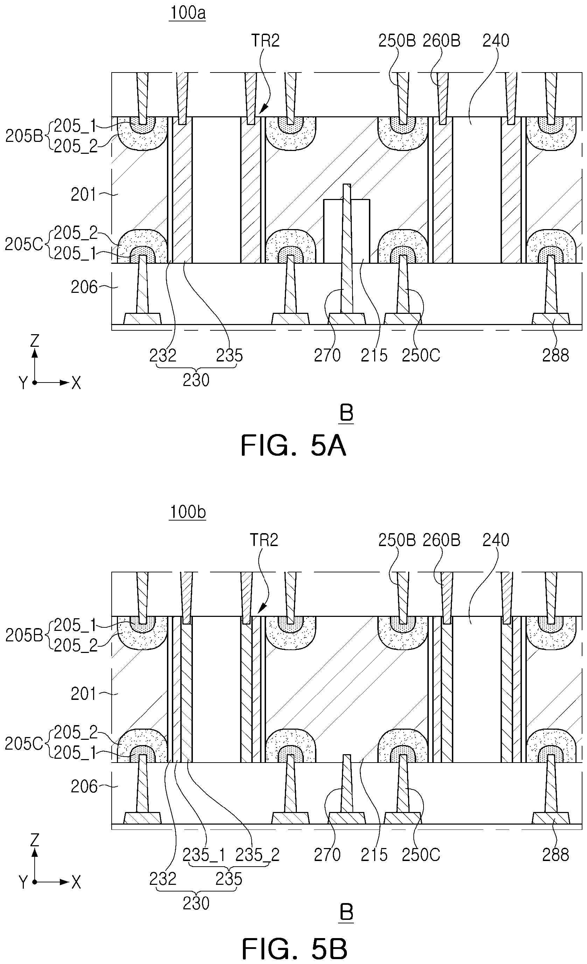

FIGS. 5A and 5B are enlarged diagrams illustrating a semiconductor device according to example embodiments, illustrating regions corresponding to FIG. 3B.

Referring to FIG. 5A, in a semiconductor device 100a, a structure of the second gate electrode layer 235 may be different from the example in the example embodiment in FIGS. 1 and 3A. In the example embodiment, a second gate electrode layer 235 may include a single conductive layer. The second gate electrode layer 235 may include, for example, a metal material, but example embodiments thereof are not limited thereto. Similarly, in example embodiments, the number of conductive layers forming the second gate electrode layer 235 may be varied.

Referring to FIG. 5B, in a semiconductor device 100b, a level of the upper end of the body contact plug 270 may be different from the example in the example embodiment in FIGS. 1 and 3A. In the example embodiment, the body contact plug 270 may be disposed by being recessed into the substrate 201 to a depth the same as or similar to that of the lower active contact plugs 250C. Accordingly, the substrate insulating layer 215 (see FIG. 3A) surrounding the body contact plug 270 may also not be provided. As such, in example embodiments, the depth of the body contact plug 270 and the form of the substrate insulating layer 215 formed therefrom may be varied.

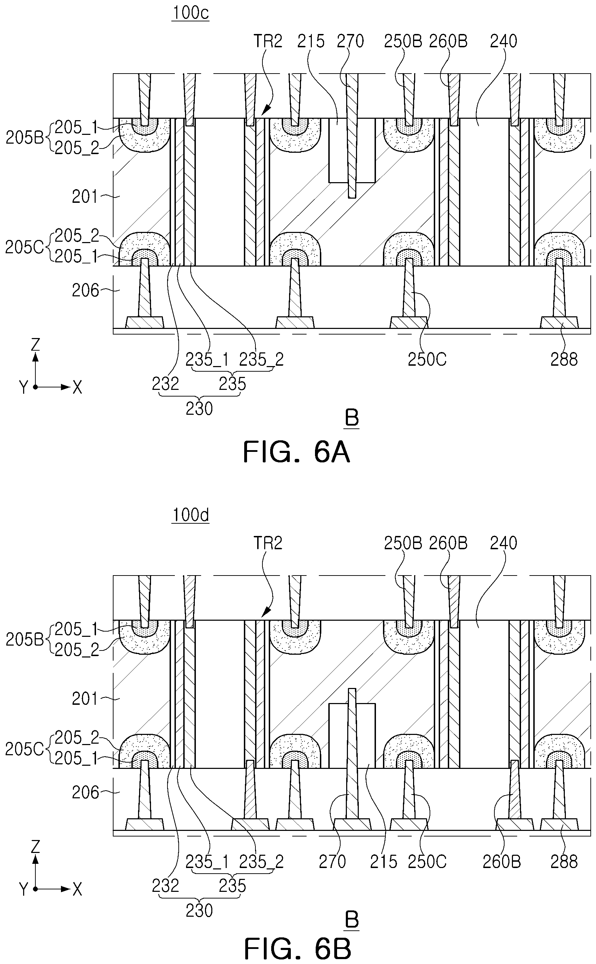

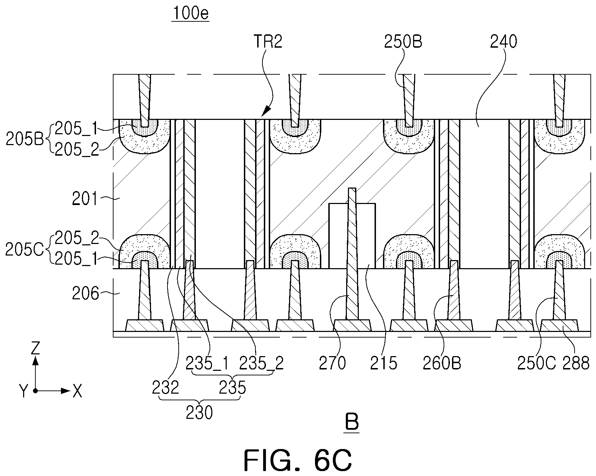

FIGS. 6A, 6B, and 6C are enlarged diagrams illustrating a portion of a semiconductor device according to example embodiments, illustrating regions corresponding to FIG. 3B.

Referring to FIG. 6A, in a semiconductor device 100c, a body contact plug 270 may be disposed to extend from an upper surface of a substrate 201 into a substrate 201. Accordingly, a substrate insulating layer 215 may also extend from the upper surface of the substrate 201 into the substrate 201. In the example embodiment, a lower end of the body contact plug 270 may be disposed on a level lower than a level of lower ends of second upper active contact plugs 250B and lower ends of second gate contact plugs 260B. The lower ends of the body contact plugs 270 may be disposed on a level higher than a level of upper ends of lower active contact plugs 250C.

Referring to FIG. 6B, in a semiconductor device 100d, a portion of the second gate contact plugs 260B may be disposed on a lower surface of the substrate 201. For example, in two second circuit devices TR2 opposing each other with the gate isolation layer 240 therebetween, the second gate contact plug 260B connected to the second gate electrode layer 235 of the second circuit device TR2 may be disposed on the upper surface of the substrate 201, and the second gate contact plug 260B connected to the second gate electrode layer 235 of the other second circuit device TR2 may be disposed on a lower surface of the substrate 201.

Referring to FIG. 6C, in a semiconductor device 100e, the entirety of the second gate contact plugs 260B may be disposed on the lower surface of the substrate 201. Accordingly, the second upper active contact plugs 250B may be disposed on the upper surface of the substrate 201, and the second gate contact plugs 260B, the lower active contact plugs 250C, and the body contact plug 270 may be disposed on the lower surface of the substrate 201.

As in FIGS. 6A, 6B, and 6C, in example embodiments, the dispositional positions of the second gate contact plugs 260B and the body contact plugs 270 may be varied. The example embodiments in FIGS. 5A, 5B, 6A, 6B, and 6C may be combined with each other in various manners.

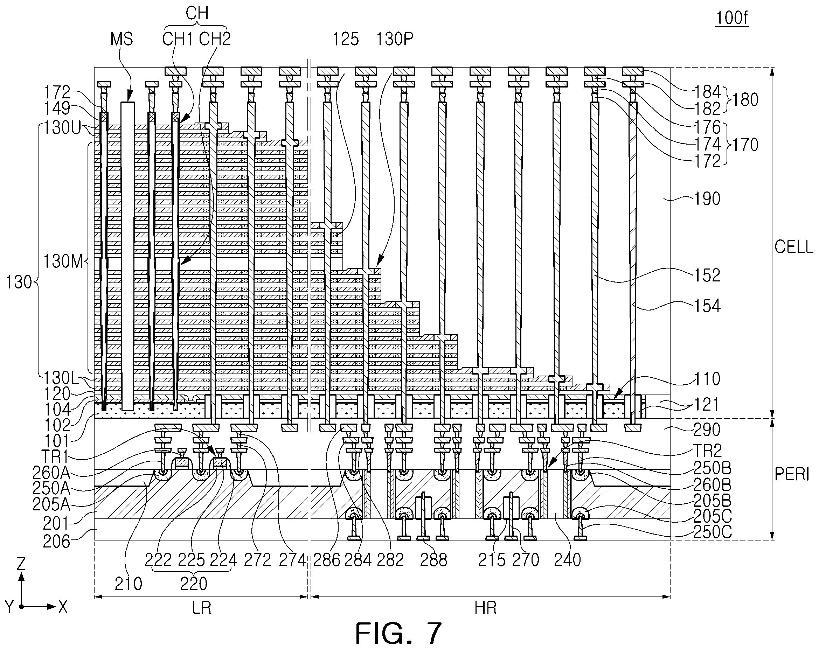

FIG. 7 is a cross-sectional view illustrating a semiconductor device according to an example embodiment.

Referring to FIG. 7, a semiconductor device 100f may include a peripheral circuit region PERI including a substrate 201 and a memory cell region CELL including a plate layer 101. The memory cell region CELL may be disposed on the peripheral circuit region PERI. In example embodiments, differently from the above example, the memory cell region CELL may be disposed below the peripheral circuit region PERI.

As for the peripheral circuit region PERI, the description of the first semiconductor structure S1 described with reference to FIGS. 1 to 4 may be applied. However, differently from the first semiconductor structure S1, the peripheral circuit region PERI may not include a first bonding vias 295, a first bonding pads 298, and a first bonding insulating layer 299, which may be a bonding structure.

As for the memory cell region CELL, unless otherwise indicated, the description of the second semiconductor structure S2 described with reference to FIGS. 1 to 4 may be applied. However, differently from the second semiconductor structure S2, the memory cell region CELL may not include a second bonding vias 195, a second bonding pads 198, and a second bonding insulating layer 199, which may be a bonding structure, and may not include a passivation layer 106. The memory cell region CELL may further include first and second horizontal conductive layers 102 and 104, a horizontal insulating structure 110, and a substrate penetrating insulating layer 121 on a plate layer 101.

The first and second horizontal conductive layers 102 and 104 may be disposed stacked in order on an upper surface of the plate layer 101. The first horizontal conductive layer 102 may function as a portion of a common source line of the semiconductor device 100f, and may function as a common source line together with the plate layer 101, for example. The first horizontal conductive layer 102 may be directly connected to the channel layer 140 around the channel layer 140 (see FIG. 4) of each of the channel structures CH. The first and second horizontal conductive layers 102 and 104 may include a semiconductor material, for example, polycrystalline silicon.

The horizontal insulating structure 110 may be disposed on the plate layer 101 in parallel with the first horizontal conductive layer 102. The horizontal insulating structure 110 may include three horizontal insulating layers stacked in order on the plate layer 101. The horizontal insulating structure 110 may be layers remaining after a portion is replaced with the first horizontal conductive layer 102 in a process of manufacturing the semiconductor device 100f. The horizontal insulating structure 110 may include silicon oxide, silicon nitride, silicon carbide, or silicon oxynitride.

The substrate penetrating insulating layer 121 may be disposed to penetrate or extend into the plate layer 101, the horizontal insulating structure 110, and the second horizontal conductive layer 104. An upper surface of the substrate penetrating insulating layer 121 may be coplanar with an upper surface of the second horizontal conductive layer 104, but example embodiments thereof is not limited thereto. The substrate penetrating insulating layer 121 may include an insulating material, for example, silicon oxide, silicon nitride, silicon carbide, or silicon oxynitride.

In example embodiments, first and second cell contact plugs 152 and 154 may penetrate or extend into the gate electrodes 130, may penetrate or extend into the substrate penetrating insulating layer 121, and may be connected to a third circuit interconnection lines 286 of the peripheral circuit region PERI.

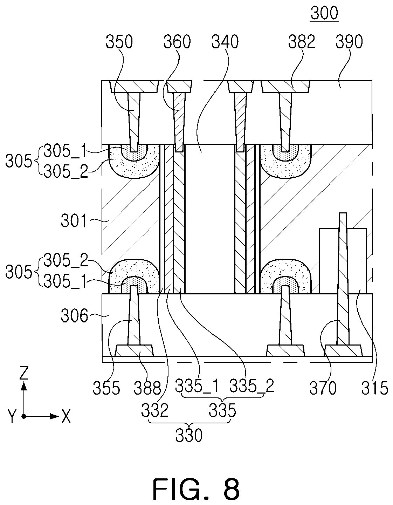

FIG. 8 is a cross-sectional view illustrating a semiconductor device according to an example embodiment.

Referring to FIG. 8, the semiconductor device 300 may include a substrate 301, a gate structure 330, source/drain regions 305, a gate isolation layer 340, upper active contact plugs 350, lower active contact plugs 355, gate contact plugs 360, and a body contact plug 370. The semiconductor device 300 may further include an upper insulating layer 390, a lower insulating layer 306, a substrate insulating layer 315, an upper interconnection line 382, and a lower interconnection line 388. A gate structure 330 and two source/drain regions 305 adjacent to the gate structure 330 may form a vertical transistor, and the semiconductor device 300 may include at least two vertical transistors opposing the gate isolation layer 340.

The substrate 301 may include a semiconductor material. The gate structure 330 may include a gate dielectric layer 332 and a gate electrode layer 335 stacked in order from an internal sidewall of the substrate 301. The gate electrode layer 335 may include first and second conductive layers 335_1 and 335_2 which may be stacked. However, the number of conductive layers forming the gate electrode layer 335 may be varied in example embodiments. The source/drain regions 305 may be disposed adjacent to an upper portion and a lower portion of the gate structure 330 in the substrate 301, respectively. The source/drain regions 305 may include first and second impurity regions 305_1 and 305_2 having different impurity concentrations, but example embodiments thereof is not limited thereto.

The upper active contact plugs 350 may be connected to source/drain regions 305 adjacent to an upper surface of the substrate 301, and the lower active contact plugs 355 may be connected to the source/drain regions 305 adjacent to a lower surface of the substrate 301. Gate contact plugs 360 may be connected to the gate electrode layer 335 and may be disposed on the upper surface of the substrate 301 or may be disposed on the lower surface of the substrate 301. The body contact plug 370 may be connected to the substrate 301 and may be disposed on the upper surface of the substrate 301 or may be disposed on the lower surface of the substrate 301. The substrate insulating layer 315 may be disposed in the substrate 301 to surround a side surface other than an end of the body contact plug 370. The gate isolation layer 340 may be disposed between vertical transistors disposed adjacent to each other and may be in contact with the gate electrode layers 335. A width of the gate isolation layer 340 may be varied in example embodiments.

Also, as for each of components of the semiconductor device 300, the description of the corresponding components of the second device region HR, described with reference to FIGS. 1 to 3B, may be applied.

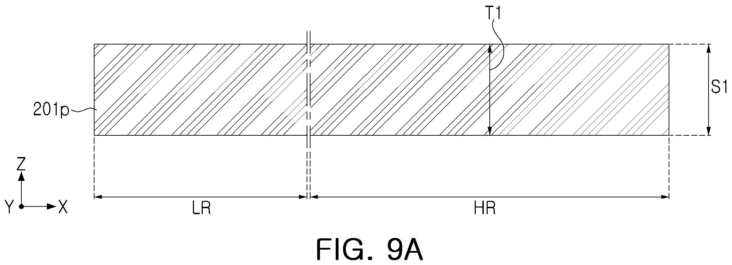

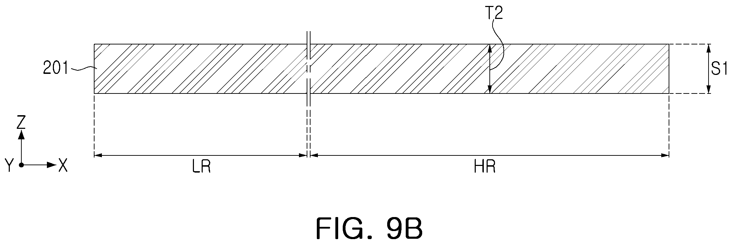

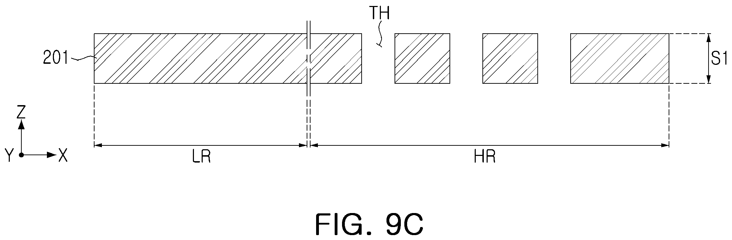

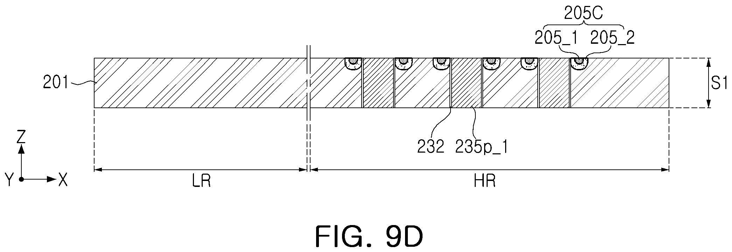

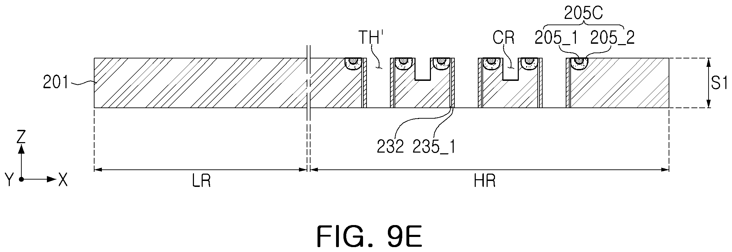

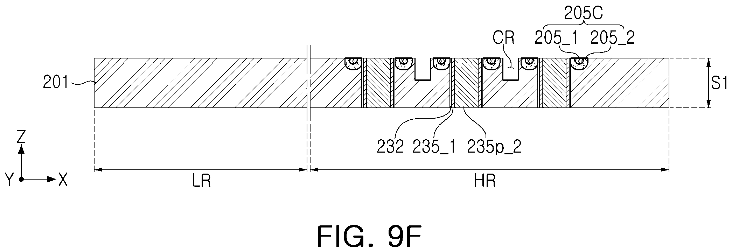

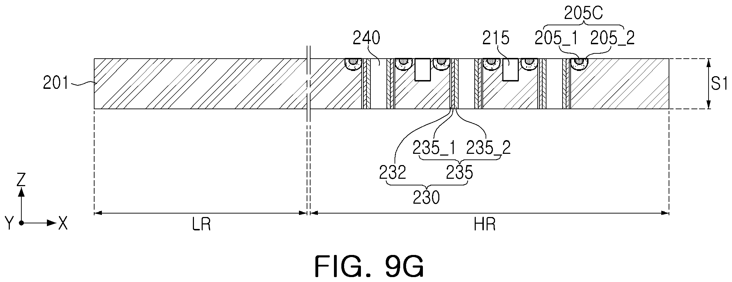

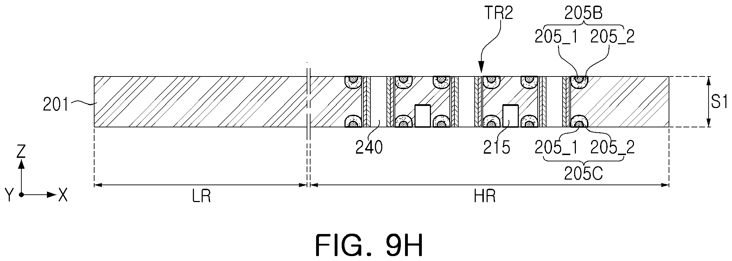

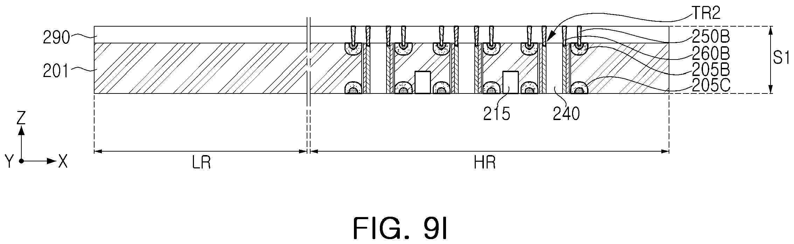

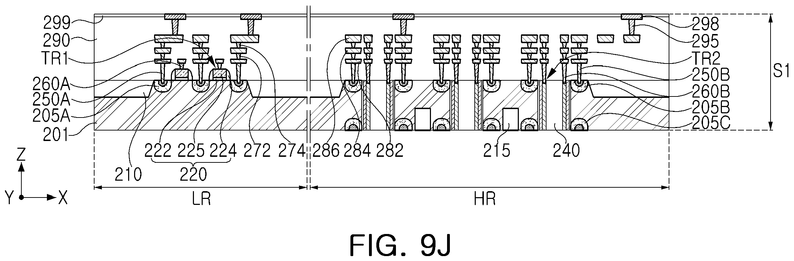

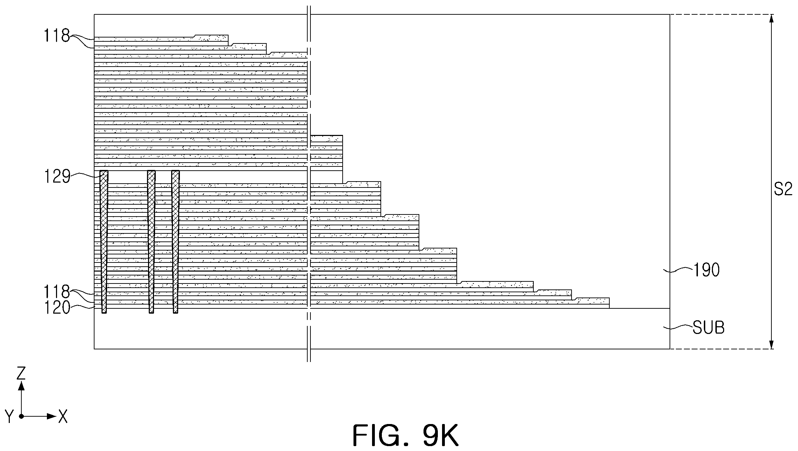

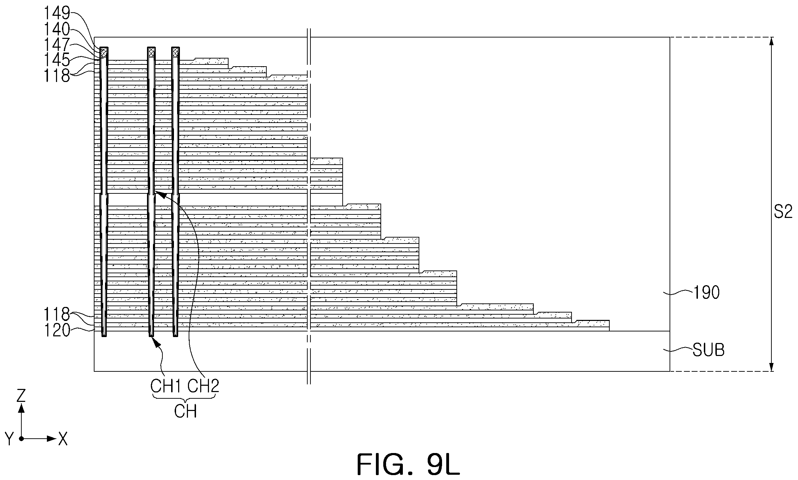

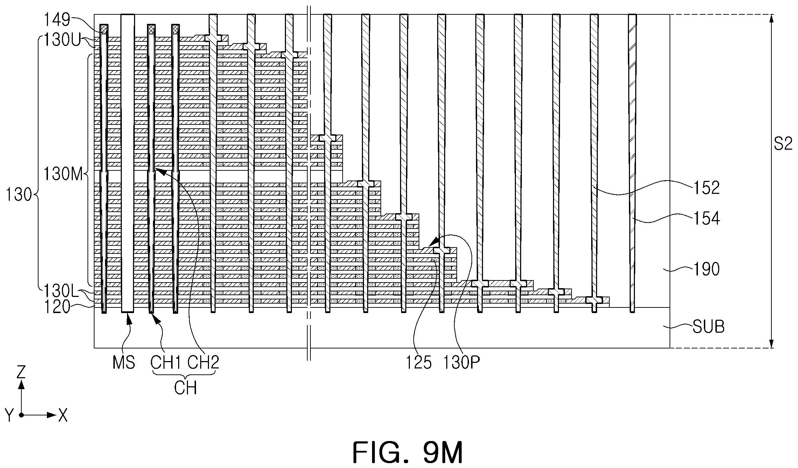

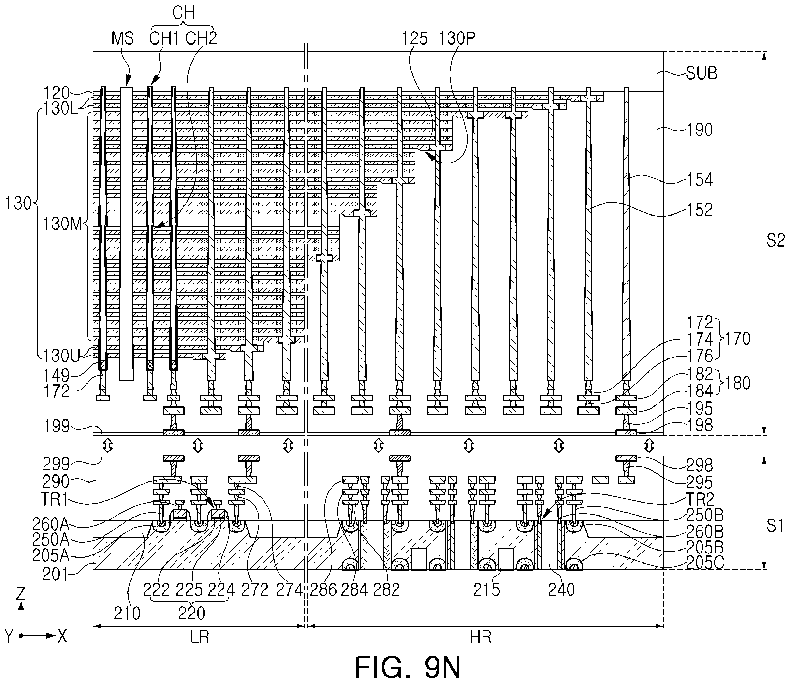

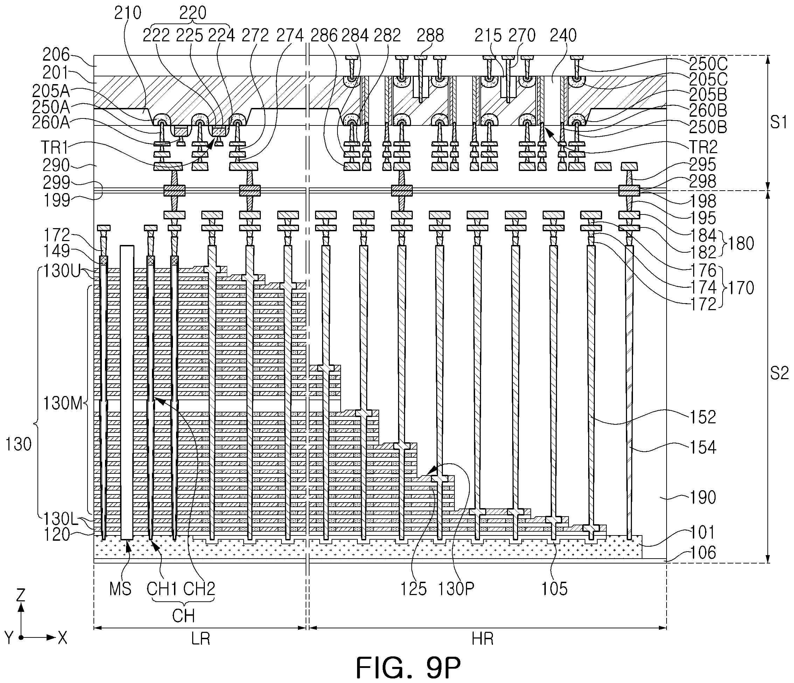

FIGS. 9A, 9B, 9C, 9D, 9E, 9F, 9G, 9H, 9I, 9J, 9K, 9L, 9M, 9N, 90, and 9P are cross-sectional views illustrating a method of manufacturing a semiconductor device according to example embodiments, illustrating regions corresponding to FIG. 1.

Referring to FIG. 9A, a preliminary substrate 201p may be prepared.

The preliminary substrate 201p may be configured as a semiconductor substrate, for example, a semiconductor wafer. The preliminary substrate 201p may have a first thickness T1. The first thickness T1 may range from tens to hundreds of micrometers, for example.

Referring to FIG. 9B, the substrate 201 may be formed by partially removing the preliminary substrate 201p.

The preliminary substrate 201p may be thinned by being removed by, for example, a lapping, grinding, polishing, or etching process. The substrate 201 may have a second thickness T2 smaller than the first thickness T1, and the second thickness T2 may be in a range of about 10 µm to about 50 µm. In this process, the substrate 201 may be prepared such that the substrate 201 in FIG. 1 may be inverted, that is, a lower surface of the substrate 201 in FIG. 1 may be disposed on an upper portion.

Referring to FIG. 9C, through-regions TH penetrating the substrate 201 may be formed.

The through-regions TH may be formed in regions corresponding to the second gate structures 330 and the gate isolation layers 340 in FIG. 3B. The through-regions TH may be formed to penetrate or extend into the entire region from an upper surface to a lower surface of the substrate 201 using, for example, an etching process. The through-regions TH may have a shape penetrating the substrate 201 and extending in one direction, for example, the Y-direction.

Referring to FIG. 9D, a second gate dielectric layer 232 and a first preliminary conductive layer 235p_1 may be formed in each of the through-regions TH, and second lower source/drain regions 205C may be formed.

The second gate dielectric layer 232 may be formed using a radical oxidation process or a deposition process on internal sidewalls of the substrate 201 exposed through the through-region TH. The first preliminary conductive layer 235p_1 may form the first conductive layer 235_1 (see FIG. 3B) through a subsequent process. The first preliminary conductive layer 235p_1 may be, for example, polycrystalline silicon, and may be formed to partially or completely fill the through-region TH through a deposition process.

The second lower source/drain regions 205C may be formed by implanting impurities into the substrate 201 through an ion implantation process. In the second lower source/drain regions 205C, the first impurity regions 205_1 may have a concentration of impurities higher than that of second impurity regions 205_2.

Referring to FIG. 9E, the first conductive layers 235_1 may be formed by partially removing the first preliminary conductive layers 235p_1 such that the through-regions TH' may be formed again, and contact openings CR may be formed.

In each of the first preliminary conductive layers 235p_1, a portion including a central region may be removed through an etching process. Accordingly, the first conductive layer 235_1 on the second gate dielectric layer 232 may be formed, and the through-regions TH' may be formed again between the first conductive layers 235_1 opposing each other.

Contact openings CR may be formed by partially removing the substrate 201. Contact openings CR may be formed together with a portion of the through-regions TH' or in a process different from the process of forming through-regions TH'. In some example embodiments, the contact openings CR may be formed in a subsequent process, such as the process described with reference to FIG. 9G.

Referring to FIG. 9F, a second preliminary conductive layer 235p_2 may be formed to partially or completely fill each of the through-regions TH'.

The second preliminary conductive layer 235p_2 may form the second conductive layer 235_2 (see FIG. 3B) through a subsequent process. The second preliminary conductive layer 235p_2 may be, for example, a metal material such as tungsten (W), and may be formed to fill the through-regions TH' through a deposition process.

Referring to FIG. 9G, the second conductive layers 235_2 may be formed by partially removing the second preliminary conductive layers 235p_2, and the gate isolation layers 240 and the substrate insulating layers 215 may be formed.

In each of the second preliminary conductive layers 235p_2, a portion including a central region may be removed through an etching process. Accordingly, a second conductive layer 235_2 may be formed on the first conductive layer 235_1. Accordingly, the second gate electrode layer 235 including the first and second conductive layers 235_1 and 235_2 may be completed, and the second gate structure 230 including the second gate dielectric layer 232 and the second gate electrode layer 235 may be completed. By filling an insulating material in the regions from which the second preliminary conductive layers 235p_2 are partially removed and the contact openings CR, the gate isolation layers 240 and the substrate insulating layers 215 may be formed, respectively.

Referring to FIG. 9H, the second upper source/drain regions 205B may be formed.

First, the structure including the substrate 201, formed as described above with reference to FIG. 9G, may be disposed upside down such that the substrate insulating layers 215 may face downwardly. As such, for the inverted structure, by performing an ion implantation process, second upper source/drain regions 205B may be formed at a predetermined depth from the upper surface of the substrate 201. Through the above processes, the second circuit devices TR2 disposed in the second device region HR may be formed.

Referring to FIG. 9I, a peripheral region insulating layer 290 may be partially formed, and the second upper active contact plugs 250B and the second gate contact plugs 260B forming a portion of the first interconnection structure may be formed.

In this process, contact plugs extending into the substrate 201 from the upper surface of the substrate 201, such as the second upper active contact plugs 250B and the second gate contact plugs 260B, may be formed. The second upper active contact plugs 250B and the second gate contact plugs 260B may be formed by partially removing the peripheral region insulating layer 290 and filling a conductive material therein.

Referring to FIG. 9J, the first circuit devices TR1 disposed in the first device region LR may be formed, and a portion of the first interconnection structure and a first bonding structure may be further formed, thereby forming a first substrate structure S1.

First, device isolation layers 210 may be formed in the substrate 201, and a first gate dielectric layer 222 and a first gate electrode layer 225 may be formed in order on the substrate 201 in the first device region LR. The device isolation layers 210 may be formed, for example, by a shallow trench isolation (STI) process. In some example embodiments, the device isolation layers 210 may be formed preferentially in a previous process, for example, the process in FIG. 9B.

The first gate dielectric layer 222 may be formed of silicon oxide, and the first gate electrode layer 225 may be formed of at least one of polycrystalline silicon, metal silicide, and/or metal material, but example embodiments thereof is not limited thereto. Thereafter, the first gate structure 220 may be formed by forming the first gate spacers 224 on both sidewalls of the first gate dielectric layer 222 and the first gate electrode layer 225. Thereafter, by performing an ion implantation process, first source/drain regions 205A may be formed in the substrate 201 on both sides of the first gate structure 220. Accordingly, the first circuit devices TR1 may be completed.

Thereafter, first upper active contact plugs 250A and first gate contact plugs 260A may be formed in the first device region LR. In some example embodiments, planar transistors such as first circuit devices TR1 may also be formed in the second device region HR.

In some example embodiments, at least a portion of components of the first circuit devices TR1, for example, at least one of the first source/drain regions 205A, the first upper active contact plugs 250A, and the first gate contact plugs 260A may be formed together with the corresponding component of the second device region HR during the process of forming the second circuit devices TR2. Also, in some example embodiments, the first circuit devices TR1 may be formed earlier than the second circuit devices TR2.

Thereafter, in the first and second device regions LR and HR, first and second circuit contact plugs 272 and 274 and first to third circuit interconnection lines 282, 284, and 286 may be formed. The first and second circuit contact plugs 272 and 274 may be formed by forming a portion of the peripheral region insulating layer 290, etching and removing a portion thereof and filling a conductive material therein. The first to third circuit interconnection lines 282, 284, and 286 may be formed, for example, by depositing a conductive material and patterning the material.

Thereafter, the first bonding insulating layer 299 may be formed on the third circuit interconnection lines 286. The first bonding vias 295 and the first bonding pads 298 of the first bonding structure may be formed after partially removing the first bonding insulating layer 299 and the peripheral region insulating layer 290.

By this process, the first substrate structure S1 may be prepared.

Referring to FIG. 9K, a process of manufacturing the second substrate structure S2 may start. First, sacrificial insulating layers 118 and interlayer insulating layers 120 may be alternately stacked on a base substrate SUB, and vertical sacrificial layers 129 may be formed.

The base substrate SUB may be removed through a subsequent process and may be configured as a semiconductor substrate such as undoped silicon (Si).

Thereafter, to form a lower stack structure, the sacrificial insulating layers 118 and the interlayer insulating layers 120 may be alternately stacked in a region in which the first channel structures CH1 (see FIG. 1) are disposed. The sacrificial insulating layers 118 may be replaced with the gate electrodes 130 (see FIG. 1) through a subsequent process. The sacrificial insulating layers 118 may be formed of a material etched with etch selectivity for the interlayer insulating layers 120. For example, the interlayer insulating layer 120 may be formed of at least one of silicon oxide and/or silicon nitride, and the sacrificial insulating layers 118 may be formed of a material different from that of the interlayer insulating layer 120, selected from among silicon, silicon oxide, silicon carbide, and/or silicon nitride. In example embodiments, a thickness of the interlayer insulating layers 120 and the number of films included therein may be varied from the illustrated example.

Thereafter, in regions including ends of the sacrificial insulating layers 118, a photolithography process and an etching process for the sacrificial insulating layers 118 and the interlayer insulating layers 120 may be performed repeatedly such that the sacrificial insulating layers 118 of the upper portion may extend to be a length shorter than the sacrificial insulating layers 118 of a lower portion. Accordingly, the sacrificial insulating layers 118 may form a staircase shape. The sacrificial insulating layers 118 may be formed to have a relatively greater thickness on ends, and processes for forming the thickness may be further performed. Thereafter, a portion of the cell region insulating layer 190 covering or overlapping a lower stack structure of the sacrificial insulating layers 118 and the interlayer insulating layers 120 may be formed.

Vertical sacrificial layers 129 may be formed by forming lower channel holes to penetrate or extend into the lower stack structure in a region corresponding to the first channel structures CH1, and depositing a material of the vertical sacrificial layers 129 in the lower channel holes. The vertical sacrificial layers 129 may include, for example, polycrystalline silicon.

The upper stack structure may be formed on the lower stack structure in the same or similar manner as the lower stack structure. Thereafter, in a region corresponding to the second channel structures CH2 (see FIG. 1), upper channel holes may be formed to penetrate or extend into the upper stack structure, and vertical sacrificial layers may be further formed. In some example embodiments, in this process, the vertical sacrificial layers may also be formed in a region corresponding to the first and second cell contact plugs 152 and 154 in FIG. 1.

Referring to FIG. 9L, channel structures CH penetrating the stack structure of sacrificial insulating layers 118 and the interlayer insulating layers 120 may be formed.

First, channel holes may be formed by removing the vertical sacrificial layers 129. Thereafter, a gate dielectric layer 145, a channel layer 140, a channel filling insulating layer 147, and a channel pad 149 may be formed in order in each of the channel holes, thereby forming the channel structures CH including first and second channel structures CH1 and CH2. The channel layer 140 may be formed on the gate dielectric layer 145 in the channel structures CH. The channel filling insulating layer 147 may be formed to fill the channel structures CH and may include an insulating material. However, in example embodiments, a space between channel layers 140 may be filled with a conductive material other than the channel filling insulating layer 147. The channel pads 149 may be formed of a conductive material, for example, polycrystalline silicon.

Referring to FIG. 9M, the sacrificial insulating layers 118 may be removed, the gate electrodes 130 may be formed, isolation region MS may be formed, and first and second cell contact plugs 152 and 154 may be formed.

First, using a mask layer, contact holes may be formed in regions in which the first contact cell plugs 152 are formed. Thereafter, a portion of the sacrificial insulating layers 118 exposed through the contact holes may be removed. Tunnel portions may be formed by removing the sacrificial insulating layers 118 to a predetermined length around the contact holes. The tunnel portions may be formed to have a relatively short length in the uppermost sacrificial insulating layers 118, and may be formed to have a relatively long length in the sacrificial insulating layers 118 therebelow. An insulating material may be deposited in the contact holes and the tunnel portions. The insulating material may be formed on sidewalls of the contact holes and may fill the tunnel portions. In the uppermost sacrificial insulating layers 118, the insulating material may not completely fill the tunnel portions. Thereafter, contact sacrificial layers filling the contact holes and uppermost the tunnel portions may be formed.

Thereafter, in a region corresponding to the isolation region MS, an opening penetrating the sacrificial insulating layers 118 and the interlayer insulating layers 120 and extending to the plate layer 101 may be formed, and an etchant may be supplied through the opening, thereby removing the sacrificial insulating layers 118. The sacrificial insulating layers 118 may be selectively removed with respect to the interlayer insulating layers 120 using wet etching, for example.

The gate electrodes 130 may be formed by depositing a conductive material in the regions from which the sacrificial insulating layers 118 are removed. The conductive material may include metal, polycrystalline silicon, or metal silicide material. After forming the gate electrodes 130, an isolation region MS may be formed by depositing an insulating material in the opening.

Thereafter, first cell contact plugs 152 may be formed by removing the contact sacrificial layers from the contact holes and depositing a conductive material. After the contact sacrificial layers are removed, a portion of the exposed insulating material may also be removed. In this case, the entirety of the insulating material may be removed from the pad regions 130P, and the insulating material may remain therebelow and may form the contact insulating layers 125. The first cell contact plugs 152 may be formed to have regions extending horizontally from the pad regions 130P and accordingly, the first cell contact plugs 152 may be physically and electrically connected to the gate electrodes 130. The second cell contact plug 154 may be formed by forming other contact holes penetrating the cell region insulating layer 190 and extending into the base substrate SUB on an external side of the gate electrodes 130, and depositing a conductive material in the contact holes. The deposition process for the conductive material may be performed simultaneously with the deposition process for the first cell contact plugs 152, but example embodiments thereof is not limited thereto.

Referring to FIG. 9N, a second interconnection structure and a second bonding structure may be formed on the gate electrodes 130, and the first substrate structure S1 and the second substrate structure S2 may be bonded to each other.

In the second interconnection structure, cell upper contacts 170 may be formed by etching the cell region insulating layer 190 on the channel pads 149 and the first and second cell contact plugs 152 and 154 and depositing a conductive material. The cell interconnection lines 180 may be formed through processes of depositing and patterning a conductive material, or by partially forming the cell region insulating layer 190, patterning the layer and depositing a conductive material.

In the second bonding structure, the second bonding insulating layer 199 may be formed on the cell region insulating layer 190. Thereafter, second bonding vias 195 may be formed by partially removing the second bonding insulating layer 199 and the cell region insulating layer 190 and depositing a conductive material, and second bonding pads 198 may be formed on the second bonding vias 195. In some example embodiments, the second bonding via 195 and the second bonding pad 198 disposed upwardly and downwardly may be formed to be integrated with each other. Upper surfaces of the second bonding pads 198 may be exposed from the cell region insulating layer 190.

Thereafter, the first substrate structure S1 and the second substrate structure S2 may be connected to each other by bonding the first bonding pads 298 to the second bonding pads 198 by annealing and/or pressurizing. Simultaneously, the first bonding insulating layer 299 and the second bonding insulating layer 199 may also be bonded to each other. The second substrate structure S2 may be disposed upside down on the first substrate structure S1 such that the second bonding pads 198 may face downwardly, and bonding may be performed. The first substrate structure S1 and the second substrate structure S2 may be directly bonded to each other without using an adhesive such as a separate adhesive layer therebetween.

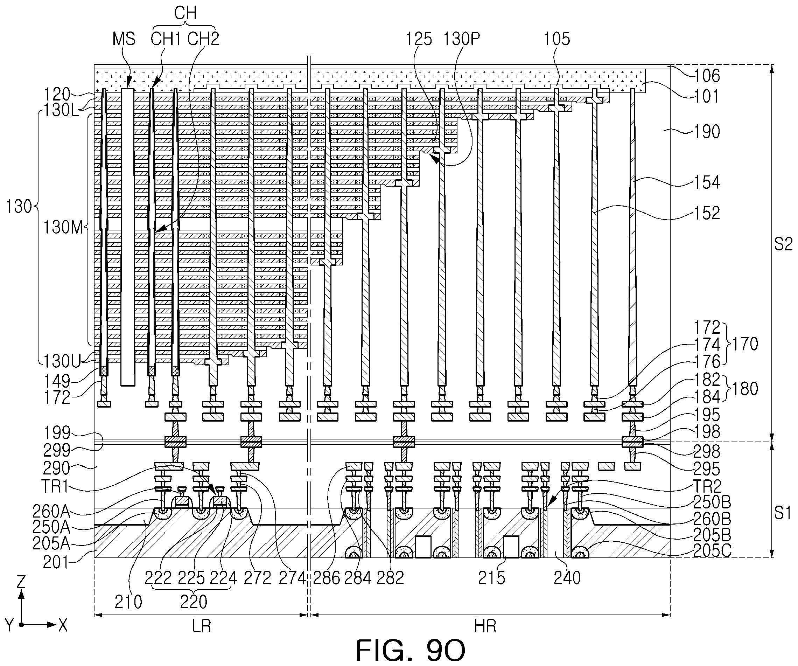

Referring to FIG. 9O, the base substrate SUB may be removed from a bonding structure of the first and second substrate structures S1 and S2, and the plate layer 101 may be formed.

For example, a portion of the base substrate SUB may be removed from an upper surface by a polishing process such as a grinding process, and the remaining portion may be removed by an etching process such as wet etching. By removing the base substrate SUB of the second substrate structure S2, a total thickness of the semiconductor device may be reduced. By removing the base substrate SUB, upper ends of the channel structures CH and the first and second cell contact plugs 152 and 154 may be exposed. A portion of the channel dielectric layers or gate dielectric layers 145 (see FIG. 4) may be removed from upper ends of the exposed channel structures CH. An insulating material may be deposited on the exposed upper ends of the first cell contact plugs 152, thereby forming a cover insulating layer 105.

A plate layer 101 may be formed by depositing a semiconductor material. The plate layer 101 may be formed, for example, by depositing amorphous silicon (Si) and crystallizing the material. A passivation layer 106 may be formed on the plate layer 101.

Referring to FIG. 9P, the bonding structure of the first and second substrate structures S1 and S2 may be reversed, and a backside insulating layer 206 may be formed on the backside of the substrate 201, and lower active contact plugs 250C, body contact plugs 270, and backside interconnection lines 288 may be formed.

First, the bonding structure may be reversed such that a backside of the substrate 201 may be disposed in an upper portion. Thereafter, a portion of the backside insulating layer 206 may be formed, and a portion thereof may be removed, thereby forming the lower active contact plugs 250C and the body contact plugs 270, and the backside interconnection lines 288 connected to the lower active contact plugs 250C and the body contact plugs 270 may be formed. In example embodiments, additional contact plugs and interconnection lines may also be formed on the backside interconnection lines 288. In some example embodiments, at least one of the processes described with reference to FIGS. 9B, 9C, 9D, 9E, 9F, and 9G may be performed in this process.

Accordingly, the semiconductor device 100 in FIG. 1 may be manufactured.

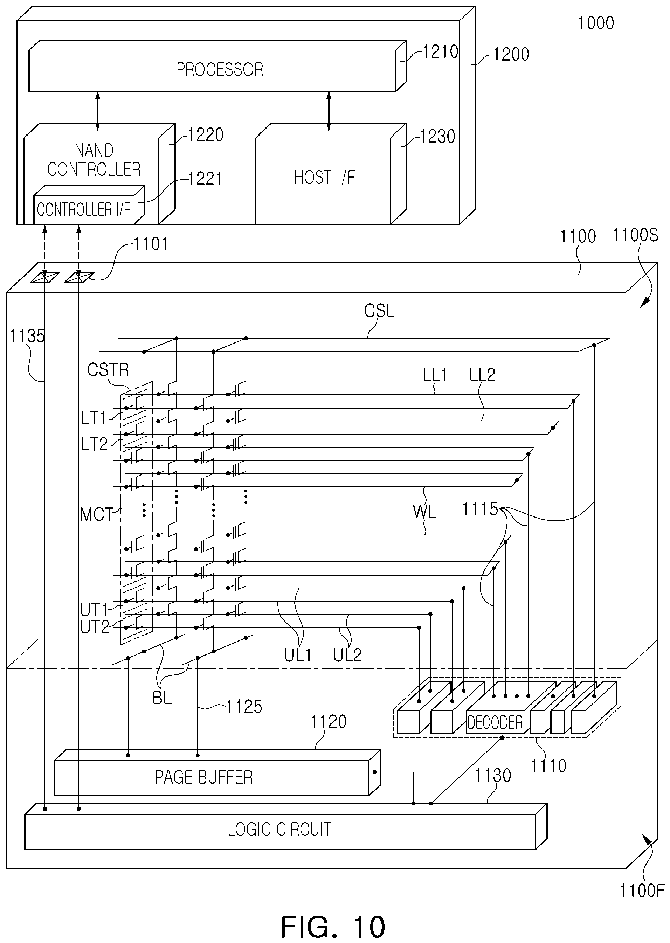

FIG. 10 is a view illustrating a data storage system including a semiconductor device according to an example embodiment.

Referring to FIG. 10, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiment with reference to FIGS. 1 to 7. The semiconductor device 1100 may include a first structure 1100F and a second structure 1100S on the first structure 1100F. In the example embodiments, the first structure 1100F may be disposed on the side of the second structure 11005. The first structure 1100F may be implemented as a peripheral circuit structure including a decoder circuit 1110, a page buffer 1120, and a logic circuit 1130. The second structure 11005 may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in the example embodiments.

In the example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The wordlines WL may be configured as gate electrodes of the memory cell transistors MCT, and the gate upper lines UL1 and UL2 may be configured as gate electrodes of the upper transistors UT1 and UT2, respectively.

In the example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending from the first structure 1100F to the second structure 11005. The bitlines BL may be electrically connected to the page buffer 1120 through second connection interconnections 1125 extending from the first structure 110F to the second structure 11005.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

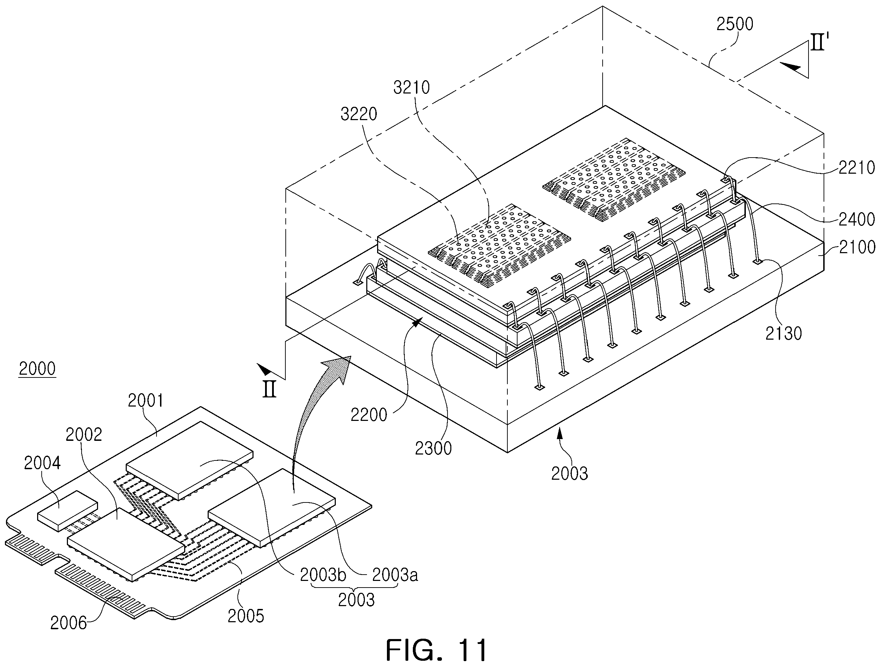

FIG. 11 is a perspective view illustrating a data storage system including a semiconductor device according to an example embodiment.

Referring to FIG. 11 a data storage system 2000 in example embodiments may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In the example embodiments, the data storage system 2000 may communicate with an external host according to one of interfaces from among universal serial bus (USB), peripheral component interconnect express (PCI-Express), serial advanced technology attachment (SATA), and/or M-Phy for universal flash storage (UFS). In the example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering or overlapping the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 10. Each of the semiconductor chips 2200 may include gate stack structures 3210 and channel structures3220. Each of the semiconductor chips 2200 may include the semiconductor device described in the aforementioned example embodiment with reference to FIGS. 1 to 7.

In the example embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In the example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the example embodiments, the controller 2002 and the semiconductor chips 2200 may be included in a single package. In example embodiments, the controller 2002 and the semiconductor chips 2200 may be mounted on an interposer substrate different from the main board 2001, and the controller 2002 and the semiconductor chips 2200 may be connected to each other by interconnection formed on the interposer substrate.

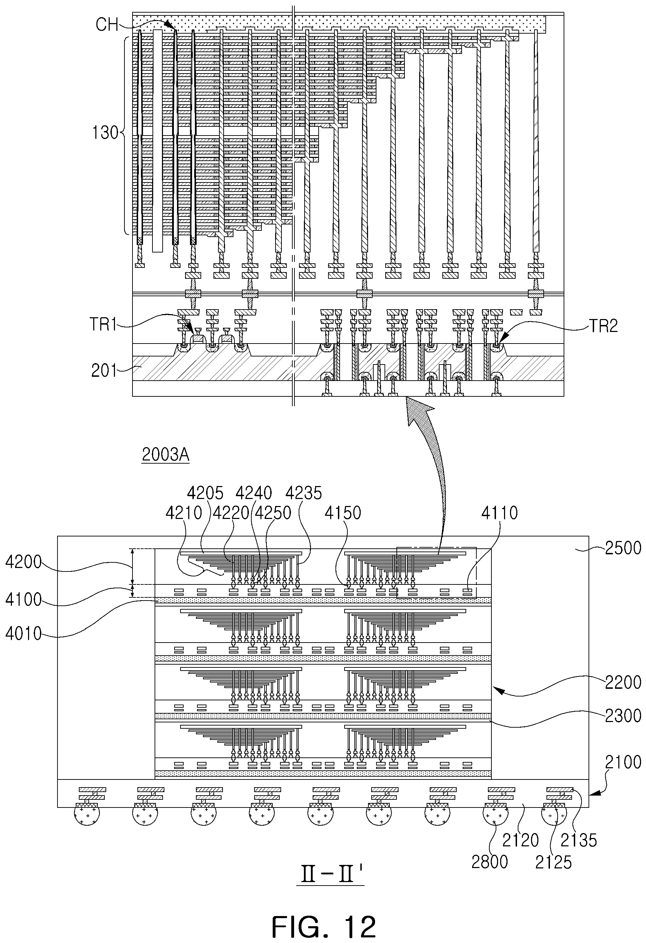

FIG. 12 is a cross-sectional view illustrating a semiconductor package according to example embodiments, illustrating example embodiments of the semiconductor package 2003 in FIG. 11 taken along line II-II'.

Referring to FIG. 12, in the semiconductor package 2003A, the package substrate 2100 may be implemented as a printed circuit substrate. The package substrate 2100 may include a package substrate body portion 2120, package upper pads 2130 (see FIG. 11) disposed on an upper surface of the package substrate body portion 2120, lower pads 2125 disposed on the lower surface of the package substrate body portion 2120 or exposed through the lower surface, and internal interconnections 2135 electrically connecting the upper package pads 2130 to the lower pads 2125 in the package substrate body portion 2120. The lower pads 2125 may be connected to the interconnection patterns 2005 of the substrate or main board 2001 of the data storage system 2000 through the conductive connection portions 2800 as illustrated in FIG. 11.

Each of the semiconductor chips 2200 may include a semiconductor substrate 4010 and a first structure 4100 and a second structure 4200 stacked in order on the semiconductor substrate 4010.

The first structure 4100 may include a peripheral circuit region including peripheral interconnections 4110 and first bonding structures 4150. The second structure 4200 may include a common source line 4205, a gate stack structure 4210 between the common source line 4205 and the first structure 4100, memory channel structures 4220 penetrating the gate stack structure 4210, and second bonding structures 4250 electrically connected to the wordlines (WL in FIG. 10) of the memory channel structures 4220 and the gate stack structure 4210. For example, the second bonding structures 4250 may be electrically connected to the memory channel structures 4220 and wordlines, through bit lines 4240 which are electrically connected to the memory channel structures 4220 and the first cell contact plugs 4235, respectively. The first bonding structures 4150 of the first structure 4100 and the second bonding structures 4250 of the second structure 4200 may be bonded to each other and may be in contact with each other. The bonded portions of the first bonding structures 4150 and the second bonding structures 4250 may be formed of copper (Cu), for example.

In each of the semiconductor chips 2200, as illustrated in the enlarged diagram, the first structure 4100 may include first circuit devices TR1 including a planar transistor and second circuit devices TR2 including a vertical transistor. Each of the semiconductor chips 2200 may further include an input/output pad (2210 in FIG. 11) electrically connected to the peripheral interconnections 4110 of the first structure 4100.

The semiconductor chips 2200 may be electrically connected to each other by connection structures 2400 in the form of bonding wires (see FIG. 11). However, in example embodiments, semiconductor chips in a semiconductor package, such as the semiconductor chips 2200, may be electrically connected to each other by a connection structure including a through electrode (TSV).

According to the aforementioned example embodiments, by including circuit devices having a backside contact vertical transistor (BCVT) structure, a semiconductor device having improved integration density and a data storage system including the same may be provided.

While the example embodiments have been illustrated and described above, it will be configured as apparent to those skilled in the art that modifications and variations could be made without departing from the scope of the present disclosure as defined by the appended claims.

Embodiments are set out in the following clauses:
Clause 1: A semiconductor device, comprising:
   a first substrate structure including a substrate, first circuit devices on the substrate, and second circuit devices that extend into the substrate; and
   a second substrate structure electrically connected to the first substrate structure on the first substrate structure and including a plate layer, gate electrodes stacked and spaced apart from each other below the plate layer in a first direction perpendicular to a lower surface of the plate layer that faces the first substrate structure, and channel structures that extend into the gate electrodes, extend in the first direction, and each include a channel layer,
   wherein each of the second circuit devices includes a second gate dielectric layer that extends into the substrate and extends in the first direction, a second gate electrode layer on the second gate dielectric layer, and second source/drain regions that extend into the substrate from opposing upper and lower surfaces of the substrate, respectively, and
   wherein the second substrate structure further includes a gate isolation layer that extends into the substrate between ones of the second circuit devices adjacent to each other and is in contact with the second gate electrode layer.
Clause 2: The semiconductor device of clause 1, wherein an upper surface of the second gate electrode layer is coplanar with the upper surface of the substrate.
Clause 3: The semiconductor device of clause 1 or 2, wherein an upper surface of the second gate dielectric layer is coplanar with the upper surface of the substrate.
Clause 4: The semiconductor device of any preceding clause,
   wherein an upper surface of one of the second source/drain regions that extends from the upper surface of the substrate is coplanar with the upper surface of the substrate, and
   wherein a lower surface of one of the second source/drain regions that extends from the lower surface of the substrate is coplanar with the lower surface of the substrate.
Clause 5: The semiconductor device of any preceding clause, wherein a pair of second circuit devices among the second circuit devices are disposed symmetrically with respect to the gate isolation layer.
Clause 6: The semiconductor device of any preceding clause, wherein the gate isolation layer includes a region having a quadrangular shape between adjacent ones of the second circuit devices in a plan view.
Clause 7: The semiconductor device of any preceding clause, wherein each of the first circuit devices includes a first gate dielectric layer on the substrate, a first gate electrode layer on the first gate dielectric layer, and first source/drain regions that extend from an upper surface of the substrate and into the substrate.
Clause 8: The semiconductor device of clause 7, wherein a second length of a portion of the second gate electrode layer that is between the second source/drain regions is greater than a first length of the first gate electrode layer between the first source/drain regions.
Clause 9: The semiconductor device of any preceding clause, wherein a length of a portion of the second gate electrode layer between the second source/drain regions is in a range of about 10 µm to about 50 µm.
Clause 10: The semiconductor device of any preceding clause, wherein the first substrate structure further comprises:
   a backside insulating layer on the lower surface of the substrate; and
   a lower active contact plug that extends into the backside insulating layer and is electrically connected to at least one of the second source/drain regions.
Clause 11: The semiconductor device of clause 10, wherein the first substrate structure further comprises:
   a body contact plug that extends into the backside insulating layer and extends into the substrate between the second source/drain regions; and
   a substrate insulating layer on a portion of a side surface of the body contact plug.
Clause 12: The semiconductor device of clause 11, wherein an upper end of the body contact plug extends into the substrate beyond an upper end of the lower active contact plug.
Clause 13: The semiconductor device of any preceding clause, wherein the first substrate structure further comprises:
   a peripheral region insulating layer on the substrate; and
   an upper active contact plug that extends into the peripheral region insulating layer and is electrically connected to the second gate electrode layer.
Clause 14: A data storage system, comprising:
   the semiconductor device of any preceding clause, the semiconductor device further comprising an input/output pad electrically connected to the first and second circuit devices; and
   a controller electrically connected to the semiconductor device by the input/output pad and configured to control the semiconductor device.
Clause 15: The data storage system of clause 14, wherein a channel of a respective one the first circuit devices extends in a direction perpendicular to a channel of a respective one of the second circuit devices.

## Claims

1. A semiconductor device, comprising:
a first substrate structure including a substrate, first circuit devices on the substrate, and second circuit devices that extend into the substrate; and
a second substrate structure electrically connected to the first substrate structure on the first substrate structure and including a plate layer, gate electrodes stacked and spaced apart from each other below the plate layer in a first direction perpendicular to a lower surface of the plate layer that faces the first substrate structure, and channel structures that extend into the gate electrodes, extend in the first direction, and each include a channel layer,
wherein each of the second circuit devices includes a second gate dielectric layer that extends into the substrate and extends in the first direction, a second gate electrode layer on the second gate dielectric layer, and second source/drain regions that extend into the substrate from opposing upper and lower surfaces of the substrate, respectively, and
wherein the second substrate structure further includes a gate isolation layer that extends into the substrate between ones of the second circuit devices adjacent to each other and is in contact with the second gate electrode layer.

2. The semiconductor device of claim 1, wherein an upper surface of the second gate electrode layer is coplanar with the upper surface of the substrate.

3. The semiconductor device of claim 1 or 2, wherein an upper surface of the second gate dielectric layer is coplanar with the upper surface of the substrate.

4. The semiconductor device of any preceding claim,
wherein an upper surface of one of the second source/drain regions that extends from the upper surface of the substrate is coplanar with the upper surface of the substrate, and/or
wherein a lower surface of one of the second source/drain regions that extends from the lower surface of the substrate is coplanar with the lower surface of the substrate.

5. The semiconductor device of any preceding claim, wherein a pair of second circuit devices among the second circuit devices are disposed symmetrically with respect to the gate isolation layer.

6. The semiconductor device of any preceding claim, wherein the gate isolation layer includes a region having a quadrangular shape between adjacent ones of the second circuit devices in a plan view

7. The semiconductor device of any preceding claim, wherein each of the first circuit devices includes a first gate dielectric layer on the substrate, a first gate electrode layer on the first gate dielectric layer, and first source/drain regions that extend from an upper surface of the substrate and into the substrate.

8. The semiconductor device of claim 7, wherein a second length of a portion of the second gate electrode layer that is between the second source/drain regions is greater than a first length of the first gate electrode layer between the first source/drain regions.

9. The semiconductor device of any preceding claim, wherein a length of a portion of the second gate electrode layer between the second source/drain regions is in a range of about 10 µm to about 50 µm.

10. The semiconductor device of any preceding claim, wherein the first substrate structure further comprises:
a backside insulating layer on the lower surface of the substrate; and
a lower active contact plug that extends into the backside insulating layer and is electrically connected to at least one of the second source/drain regions.

11. The semiconductor device of claim 10, wherein the first substrate structure further comprises:
a body contact plug that extends into the backside insulating layer and extends into the substrate between the second source/drain regions; and
a substrate insulating layer on a portion of a side surface of the body contact plug.

12. The semiconductor device of claim 11, wherein an upper end of the body contact plug extends into the substrate beyond an upper end of the lower active contact plug.

13. The semiconductor device of any preceding claim, wherein the first substrate structure further comprises:
a peripheral region insulating layer on the substrate; and
a gate contact plug that extends into the peripheral region insulating layer and is electrically connected to the second gate electrode layer.

14. A data storage system, comprising:
the semiconductor device of any preceding claim, the semiconductor device further comprising an input/output pad electrically connected to the first and second circuit devices; and
a controller electrically connected to the semiconductor device by the input/output pad and configured to control the semiconductor device.

15. The data storage system of claim 14, wherein a channel of a respective one of the first circuit devices extends in a direction perpendicular to a channel of a respective one of the second circuit devices.
